(19) Europäisches Patentamt
European Patent Office
Office européen des brevets

(11) **EP 2 815 004 B1**

(12) **EUROPÄISCHE PATENTSCHRIFT**

(45) Veröffentlichungstag und Bekanntmachung des Hinweises auf die Patenterteilung:
**10.01.2018 Patentblatt 2018/02**

(21) Anmeldenummer: **13712740.3**

(22) Anmeldetag: **21.03.2013**

(51) Int Cl.:
*C30B 25/18* *(2006.01)*     *C30B 25/10* *(2006.01)*
*C30B 25/16* *(2006.01)*     *C30B 29/40* *(2006.01)*
*H01L 21/02* *(2006.01)*

(86) Internationale Anmeldenummer:
**PCT/EP2013/055891**

(87) Internationale Veröffentlichungsnummer:
**WO 2013/139887 (26.09.2013 Gazette 2013/39)**

(54) **VERFAHREN ZUR HERSTELLUNG VON III-N-EINKRISTALLEN, UND III-N-EINKRISTALL**

METHOD FOR PRODUCING III-N SINGLE CRYSTALS, AND III-N SINGLE CRYSTAL

PROCÉDÉ DE PRODUCTION DE MONOCRISTAUX DE III-N, ET MONOCRISTAUX DE III-N

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.03.2012 DE 102012204551**
**21.03.2012 DE 102012204553**
**22.03.2012 US 201261614161 P**
**22.03.2012 US 201261614190 P**

(43) Veröffentlichungstag der Anmeldung:
**24.12.2014 Patentblatt 2014/52**

(73) Patentinhaber: **Freiberger Compound Materials GmbH**
**09599 Freiberg (DE)**

(72) Erfinder:
• **GRÜNDER, Marit**
**10245 Berlin (DE)**
• **BRUNNER, Frank**
**12051 Berlin (DE)**
• **RICHTER, Eberhard**
**10318 Berlin (DE)**
• **HABEL, Frank**
**09599 Freiberg (DE)**
• **WEYERS, Markus**
**15745 Wildau (DE)**

(74) Vertreter: **Prüfer & Partner mbB**
**Patentanwälte · Rechtsanwälte**
**Sohnckestraße 12**
**81479 München (DE)**

(56) Entgegenhaltungen:
WO-A1-2007/068756     US-A1- 2002 068 201
US-A1- 2003 232 457     US-B1- 6 440 823

• BRUNNER F ET AL: "Quantitative analysis of in situ wafer bowing measurements for III-nitride growth on sapphire", JOURNAL OF CRYSTAL GROWTH, ELSEVIER, AMSTERDAM, NL, Bd. 310, Nr. 10, 1. Mai 2008 (2008-05-01), Seiten 2432-2438, XP022620125, ISSN: 0022-0248, DOI: 10.1016/J.JCRYSGRO.2008.01.024 [gefunden am 2008-01-26]
• MISKYS C R ET AL: "GaN homoepitaxy by metalorganic chemical-vapor deposition on free-standing GaN substrates", APPLIED PHYSICS LETTERS, A I P PUBLISHING LLC, US, vol. 77, no. 12, 18 September 2000 (2000-09-18), pages 1858-1860, XP012026182, ISSN: 0003-6951, DOI: 10.1063/1.1311596
• MARTINEZ-CRIADO G ET AL: "Free-standing GaN grown on epitaxial lateral overgrown GaN substrates", JOURNAL OF CRYSTAL GROWTH, ELSEVIER, AMSTERDAM, NL, vol. 255, no. 3-4, 1 August 2003 (2003-08-01), pages 277-281, XP004434559, ISSN: 0022-0248, DOI: 10.1016/S0022-0248(03)01293-4

**Beschreibung**

Die vorliegende Erfindung betrifft Verfahren zur Herstellung von Verbundsubstraten (im Folgenden "Templat(e)" genannt) und zur Herstellung von III-N-Einkristallen. Die erfindungsgemäßen Verfahren ermöglichen die Herstellung von rissfreien III-N-Einkristallen, die insbesondere für die Verwendung als Wafer geeignet sind. III bedeutet mindestens ein Element der dritten Hauptgruppe des Periodensystems, ausgewählt aus der Gruppe von Al, Ga und In.

III-N-Einkristalle sind von großer technischer Bedeutung. Auf diesen Materialien beruhen eine Vielzahl von Halbleiterbauelementen und optisch-elektrischer Bauelemente wie Leistungsbauelemente, Hochfrequenzbauelemente, lichtemittierende Dioden und Laser. Bei der Herstellung solcher Vorrichtungen wird häufig epitaxiales Kristallwachstum auf einem Startsubstrat durchgeführt, oder es wird auf einem Startsubstrat zunächst ein Templat gebildet, worauf nachfolgend durch weiteres epitaxiales Wachstum III-N-Schichten bzw. -Einkristallkörper gewachsen werden können. Als Startsubstrate können III-N-Substrate oder insbesondere Fremdsubstrate verwendet werden. Bei Verwendung von Fremdsubstraten kann es während des Wachstums aufgrund der Unterschiede der thermischen Ausdehnungskoeffizienten von Startsubstrat und aufgewachsener Schicht zu Verspannungen und Rissen innerhalb einer III-N-Schicht kommen. Dickere Schichten bis zu 1 mm können auch unter Zuhilfenahme von zum Teil strukturierten Zwischenschichten aus WSiN, TiN oder $SiO_2$ gewachsen werden und im Anschluss als freistehende Schichten abgelöst werden, die typischerweise plastische, konkav verbogene c-Gitterebenen und Oberflächen aufweisen. Insbesondere wenn in einem solchen Verfahren auf eine Zwischenschicht verzichtet wird, können an und oberhalb der Grenzfläche zwischen Startsubstrat und aufgewachsener III-N-Schicht vertikale und horizontale Mikrorisse entstehen, die sich mit der Zeit ausdehnen und zum Bruch der GaN-Schicht bei oder nach dem Abkühlungsprozess führen können. Aus Untersuchungen von Hearne et al., Applied Physics Letters 74, 356-358 (1999) ist bekannt, dass während der Abscheidung von GaN auf Saphirsubstrat sich ein mit dem Wachstum zunehmender instrinsischer tensile Verspannung (Stress) aufbaut. Ein *in situ* Stress Monitoring ergab, dass die durch das Wachtum erzeugte tensile Verspannung sich nicht messbar durch Annealing oder Thermal Cycling relaxieren lässt. Das bedeutet unter anderem, dass eine am Wachstumsende der GaN-Schicht erhaltene Verspannung nach Abkühlen und Wiederaufheizen auf die gleiche (Wachstums-)Temperatur wieder den gleichen Wert annimmt. Bei Hearne et al. findet man auch eine Erläuterung der Hintergründe, Zusammenhänge und Beobachtungsmöglichkeiten von extrinstischer (nämlich durch unterschiedliche thermische Ausdehnungskoeffizienten zwischen Saphirsubstrat und GaN-Schicht generierter) und instrinsischer (nämlich durch Wachstum erzeugter) Verspannung (Stress).

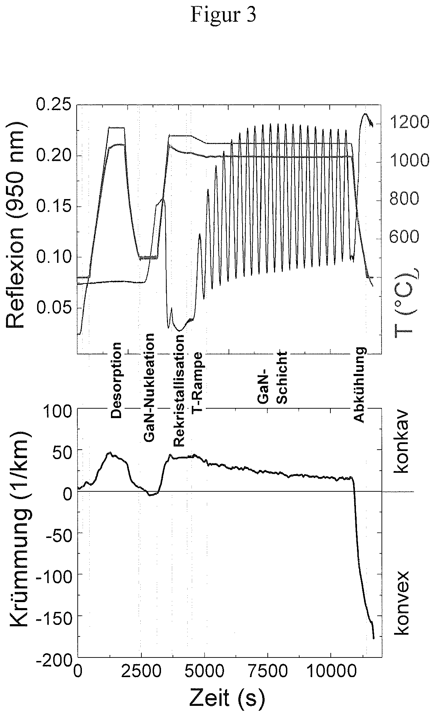

In Journal of Crystal Growth 289, 445-449 (2006) wird von Napierala et al. diesbezüglich ein Verfahren zur Herstellung von GaN/Saphirtemplaten beschrieben, auf dem rissfreie dünne GaN-Schichten aufgewachsen werden, indem die intrinsische Verspannung im Galliumnitrid durch das Einstellen der Dichte von Galliumnitrid-Kristalliten kontrolliert werden kann, sodass Verspannungen in den dünnen Schichten durch Verbiegen freigesetzt werden können. Jedoch können dicke Schichten in diesem Verfahren den Druck während des Wachsens nicht kompensieren und neigen trotz der Verbiegung zu Brüchen. Richter et al. (E. Richter, U.Zeimer, S.Hagedorn, M.Wagner, F.Brunner, M.Weyers, G.Tränkle, Journal of Crystal Growth 312, [2010] 2537) beschreiben ein Verfahren zur Herstellung von GaN-Kristallen über Hydridgasphasenepitaxie (HVPE), bei dem GaN-Schichten von 2,6 mm rissfrei gewachsen werden können über die Einstellung des partiellen Galliumchloriddrucks, wobei die erhaltenen GaN-Schichten auf der Oberfläche eine Vielzahl von V-Pits aufweisen. Ein mit diesem Prozess gewachsener Kristall besitzt eine Dicke von 5,8 mm, allerdings weist er längere Risse auf. In Journal of Crystal Growth 298, 202-206 (2007) zeigen Brunner et al. den Einfluss der Schichtdicke auf die Krümmung der aufwachsenden III-N-Schicht auf. Es wird das Wachstum von GaN und AlGaN, ggf. mit InGaN-Komplianz-Schicht, auf GaN-Saphir-Templat untersucht. Dabei hat sich gezeigt, dass für GaN und AlGaN mit 2,8% und 7,6% Al-Molanteil die konkave Krümmung während des Wachstums zunimmt, was gemäß Beobachtung mit der Generierung einer tensilen Verspannung einhergeht (vgl. Fig. 3). Ferner nimmt die konkave Krümmung dabei mit aufsteigendem Aluminiumgehalt zu, entsprechend nimmt die tensile Verspannung weiter zu. Zusätzlich wird der Einfluss einer Si-dotierten Indium-Gallium-Nitridschicht auf das Wachstum einer AlGaN-Schicht mit 7,6% Al-Molanteil auf eine GaN-Pufferschicht gezeigt. Dazu wird einerseits eine AlGaN-Schicht mit 7,6% Al-Molanteil direkt auf eine GaN-Pufferschicht aufgewachsen und andererseits eine Si-dotierten Indium-Gallium-Nitridschicht als Zwischenschicht auf eine GaN-Pufferschicht, wobei im Anschluss eine AlGaN-Schicht mit 7,6% Al-Molanteil auf die Zwischenschicht aufgewachsen wird. So wurde gezeigt, dass das Auftragen einer Si-dotierten Indium-Gallium-Nitridschicht auf eine GaN-Pufferschicht zu kompressiver Verspannung in dem Kristall führt. Während dieses Verfahrens wird die zunächst konkave Krümmung der GaN-Pufferschicht im Zuge einer Temperaturabsenkung in eine leicht konvexe Krümmung überführt, und durch Aufwachsen einer $In_{0,06}GaN$-Schicht innerhalb desselben Verfahrens nimmt diese konvexe Krümmung im weiteren Wachstum zu. Bei der anschließenden Auftragung einer $Al_{0,076}GaN$-Schicht auf dieser $In_{0,06}GaN$-Schicht wird schließlich eine konkave Krümmung erreicht, die vergleichsweise geringer ausfällt als die resultierende Krümmung ohne $In_{0,06}GaN$-Zwischenschicht.

E. Richter, M. Gründer, B. Schineller, F. Brunner, U. Zeimer, C. Netzel, M. Weyers und G. Tränkle (Phys. Status Solidi C 8, No. 5 (2011) 1450) beschreiben ein Verfahren zur Herstellung von GaN-Kristallen mittels HVPE, wobei eine Dicke bis zu 6,3 mm erreicht werden kann. Diese Kristalle zeigen schräg geneigte Seitenwände und V-Pits auf der Oberfläche. Des Weiteren zeigt sich im Kristallgitter eine konkave Krümmung von ca. 5,4 m und eine Versetzungsdichte von $6\times10^{-5}$ cm$^{-2}$, US 2009/0092815 AI beschreibt die Herstellung von Aluminiumnitridkristallen zwischen 1 und 2 mm Dicke sowie Aluminiumnitridschichten mit 5 mm Dicke. Diese Schichten werden als rissfrei beschrieben und können herangezogen werden, um farblose und optisch durchsichtige Wafer zu schneiden mit mehr als 90% nutzbarer Fläche für die Anwendung in der Bauteilherstellung oder Bauelementherstellung.

F. Brunner, A. Knauer, T. Schenk, M. Weyers und J.-T. Zettler (Journal of Crystal Growth 310 (2008), 2432-2438) beschreiben eine quantitative Analyse von Waferkrümmungsmessungen für III-N-Materialien auf Saphir. Hierbei konnten insbesondere die Gitterkonstanten von AlGaN und InGaN bestimmt werden.

US 6,440,823 B1 offenbart ein HVPE-Verfahren zur Herstellungvon GaN, AlN und InN mit einer niedrigen Defektdichte.

US 2002/0068201 A1 beschreibt ein freistehendes AlN, GaN und InN und dessen Herstellung mittels eines Opfertemplats.

US 2003/023457 A1 beschreibt ein Herstellungsverfahren für ein Nitrid-Halbleitermaterial mit einer spezifizierten Temperatursequenz.

WO 2007/068756 A1 beschreibt ein Verfahren zur Herstellung von GaN mit niedriger Versetzungsdichte mit Hilfe eines Wechsels von 3D-Wachstum und 2D-Wachstum.

Den Verfahren des vorbeschriebenen Stands der Technik ist gemein, dass nach Wachstum und Abkühlung III-N-Kristalle erhalten werden, die starker extrinsischer und intrinsischer Verspannung ausgesetzt sind, wodurch Risse oder andere Materialfehler entstehen können, die die Materialqualität und die Verarbeitbarkeit zu III-N-Substraten einschränken.

Daher war es Aufgabe der vorliegenden Erfindung, Herstellungsverfahren für Template und III-N-Kristalle bereitzustellen, die es ermöglichen, III-N-Kristalle unter Bedingungen zu wachsen, die den Einschluss von Materialfehlern minimiert und die Kristallqualität sowie die Verarbeitbarkeit verbessert.

Diese Aufgabe wird durch die Verfahren gemäß der Ansprüche 1 und 5 gelöst. Weiterbildungen sind in den entsprechenden Unteransprüchen angegeben. Weiterhin stellt die Erfindung an Fremdsubstrat anhaftende III-N-Einkristalle gemäß Anspruch 12 bereit, mit entsprechenden Weiterbildungen der Unteransprüche dazu. Eine nützliche Verwendung ist im Anspruch 15 definiert.

Erfindungsgemäß wurde überraschend gefunden, dass III-N-Einkristalle rissfrei und unter kontrollierbarer kompressiver Verspannung gewachsen werden können, wenn auf einem Substrat Kristallwachstum bei einer ersten Kristallwachstumstemperatur durchgeführt wird und anschließend die zuvor angewandte Temperatur auf eine zweite Temperatur verändert wird, und wenn dann im Bereich der gegenüber der ersten Kristallwachstumstemperatur veränderten zweiten Temperatur weiteres Kristallwachstum erfolgt. Wie die angewandte Temperatur verändert wird hängt von der Art des für den Prozess gewählten Substrats ab. Hat das Substrat einen höheren thermischen Ausdehungskoeffizienten als der zu wachsende III-N-Einkristall, so ist die anzuwendende Veränderung eine Temperaturabsenkung unterhalb der zuvor angewandten ersten Temperatur. Hat das Substrat hingegen einen niedrigeren thermischen Ausdehungskoeffizienten als der zu wachsende III-N-Einkristall, so ist die anzuwendende Veränderung eine Temperaturerhöhung oberhalb der zuvor angewandten ersten Temperatur.

Dadurch wird es möglich, dass erfindungsgemäß in einem Templat (d.h. einer Einheit mit Substrat und relativ dünner III-N-Kristallschicht, wobei eine solche Templat-Einheit ihrerseits als Ausgangsprodukt zur anschließenden Herstellung von III-N-Kristall-Boules/Ingots oder von III-N-Bauelementen fungiert) die als wichtig erkannten, kritischen Parameter Krümmung und Verspannung des Templats - jeweils alternativ oder kombiniert - richtig und gezielt beeinflusst werden kann für vorteilhafte Eigenschaften des Templats und dessen Weiterverwendung, wodurch vor allem einer späteren Rissbildung unter Verwendung des erfindungemäßen Templats wirksam entgegengewirkt werden kann. Zu den erfindungsgemäß relevanten und für die Weiterverwendung des Templats günstigen Einstellungen der Krümmung gehört es, gemäß alternativer technischer Lösungen dafür zu sorgen, (i) dass eine später noch näher spezifizierte Krümmungsdifferenz $(K_a-K_e)$ in mindestens einer Wachstumsphase bei der Templatherstellung auf den Bereich $\geq 0$ und insbesondere $>0$ eingehalten wird, oder (ii) dass das hergestellte Templat im Zustand auf Wachstumstemperatur nicht gekrümmt oder im wesentlichen nicht gekrümmt ist oder negativ (konvex) gekrümmt ist. Erfindungsgemäß können Template hergestellt werden, die unter epitaxialen Kristallwachstumsbedingungen keine oder annähernd keine Krümmung oder eine negative Krümmung und damit nur eine geringe intrinsische Spannung aufweisen, was sich als Ausgangssituation für die Weiterverarbeitung als vorteilhaft herausgestellt hat.

Das erfindungsgemäße Verfahren, und in verstärktem Maße durch Beachtung der bevorzugten Merkmale des erfindungsgemäßen Verfahrens, erlaubt entsprechend eine vorteilhafte Einstellung der Verspannung in der III-N-Kristallschicht des Templats mit einem Wert $\varepsilon_{xx}$ bei Raumtemperatur in einem vorteilhaften Bereich von $\varepsilon_{xx}<0$, speziell in besonders passenden negativen von $\varepsilon_{xx}$-Werten, was sich auf die Weiterverwendung des Templats sehr günstig auswirkt und somit ein relevantes Produktmerkmal des Templats darstellt.

Herkömmliche Verfahren haben bisher ein ganz anderes Verhalten gezeigt. In herkömmlichen Verfahren wird ein Kristallwachstum ebenfalls bei einer bestimmten gewünschten Temperatur durchgeführt. Diese Temperatur entspricht einer als geeignet angesehenen Temperatur für das jeweilige III-N-Material. Selbst wenn es vorkommen kann, dass in einem Aufwachsverfahren die Temperatur gesenkt wird, um ein anderes III-N-Material aufzuwachsen, so wird dennoch zu Beginn oder während des Wachstums bei dieser bestimmten, neuen Temperatur die Temperatur nicht weiter abgesenkt, sondern konstant gehalten. In einem solchen herkömmlichen Fall steigt aber typischerweise eine gegebene Krümmung der Wachstumsoberfläche, ob konvex oder konkav, während des Wachstums stetig an. Überraschend kann das erfindungsgemäße Verfahren so gestaltet werden, dass während einer bestimmten Wachstumsphase der III-N-Materialschicht des Templats eine gegebene Krümmung trotz des weiteren Wachstums einer gegebenen der III-N-Materialschicht abnimmt. Ferner wird bei herkömmlichen Verfahren infolge einer stetig ansteigenden Krümmung eine entsprechend steigende intrinsische - typischerweise tensile - Spannung innerhalb des Kristalls aufgebaut, die gegebenenfalls bereits während des weiteren Wachstums, spätestens bei Abkühlung von der epitaxialen Wachstumstemperatur, zu Mikrorissen bis hin zu Brüchen führen kann. Demgegenüber kann beim Verfahren der vorliegenden Erfindung eine kontrolliert eingestellte intrinsische - typischerweise kompressive-Spannung beim epitaxialen Kristallwachstum gering gehalten werden, so dass während des fortgesetzten Wachstums und selbst beim Abkühlen Risse vermieden werden können, also rissfreies Wachstum von III-N-Kristallen erreicht werden kann.

Als alternative und gegebenenfalls kombiniert anzuwendende, neue Möglichkeit, die oben beschrieben günstige Krümmungsdifferenz ($K_a$-$K_e$) und/oder Nichtkrümmung, die im wesentlichen Nichtkrümmung oder die negative (konvex) Krümmung im Sinne der Erfindung günstig zu beeinflussen und unter passenden Bedingungen einzustellen, beruht auf der prozesstechnischen Maßnahme, dass während des Wachstums, oder in einer intermittierenden Zwischenstufe zu Beginn oder zwischen Beginn und Fortsetzung des Wachstums, eines kristallinen III-N-Materials auf dem Substrat ein Maskenmaterial als Zwischenschicht auf dem Substrat, welches gegebenenfalls eine III-N-Nukleationsschicht aufweist, oder im eigentlichen kristallinen III-N-Material in einem bestimmten maximalen Abstand vom Substrat oder der gegebenenfalls vorgesehenen III-N-Nukleationsschicht abgeschieden wird und danach das Wachstum des kristallinen III-N-Materials erfolgt oder fortgesetzt wird. Die Zwischenschicht des Maskenmaterials, die vorzugsweise als eine einzige dünne, in der Regel sehr dünne Schicht ausgebildet ist und deren Beschaffenheit unten noch näher beschrieben wird, wird dabei bei einem maximalen Abstand vom Substrat, bzw. der gegebenenfalls darauf gebildeten III-N-Nukleationsschicht, von 300nm, bevorzugt bei einem Abstand von unter 300nm, weiter bevorzugt unter 250nm, noch weiter bevorzugt unter 100nm, insbesondere bis maximal 50nm, abgeschieden.

Bei dieser alternativen Methode der bezeichneten Einstellung des Krümmungsverhaltens wird darauf geachtet, dass Maskenmaterial als Zwischenschicht zumindest teilweise direkt auf dem Substrat oder der gegebenenfalls vorhandenen III-N-Nukleationsschicht darauf (d.h. unmittelbar angrenzend), oder im kristallinen III-N-Material des Templats in einem passenden Abstand zu der Hauptoberfläche des Substrats oder der gegebenenfalls vorhandenen III-N-Nukleationsschicht darauf (d.h. dort wo der Kontakt zu Substrat bzw. III-N-Nukleationsschicht stattfindet) abzuscheiden. Dies gilt auch dann, wenn optional Oberflächenstrukturierungen auf dem Substrat bereitgestellt werden und daher der vorbeschriebene Kontakt nur teilweise stattfindet; solche Oberflächenstrukturierungen beziehen sich nämlich lediglich auf herkömmliche, *ex situ* durchgeführte Musterungen, wie z.B. das Öffnen von Fenstern, das Bilden von Streifen oder Punkten und anderer Maskenstrukturen, etwa mittels (Photo-) Lithographie, herkömmliche Fälle also, in denen das erwünschte Krümmungsverhalten nicht wie gemäß der Erfindung eingestellt werden kann. Außerdem sind die Dimensionen unterschiedlich: *ex situ* durchgeführte Oberflächenmaskierungen und -muster weisen typischerweise eine Dickendimension im $\mu$m-Bereich auf, wohingegen die *in situ* eingebrachte Maskenmaterial-Zwischenschicht, die erfindungsgemäß optional oder ergänzend angewandt wird, typischerweise eine Dickendimension im sub-$\mu$m-Bereich aufweist.

In einem so bereitgestellten III-N-Kristall kann vermieden werden, dass Risse entstehen, die die Materialqualität und/oder die Verarbeitbarkeit zu III-N-Substraten einschränkt.

"Rissfreier III-N-Kristall" gemäß der vorliegenden Erfindung bedeutet, dass er auf einer Fläche von 15 cm$^2$ (entsprechend 3 mm Randausschluss bei 2 Zoll) bei Ansicht von jeweils 30 mm$^2$ Bildausschnitten mit einem optischen Mikroskop keinen Riss aufweist.

Gemäß der vorliegenden Erfindung kann ferner die mikroskopische Eigenschaft der Deformation $\varepsilon_{xx}$ der Gitterkonstante a beeinflusst werden. Die Deformation $\varepsilon$ wird in der Mechanik allgemein auch als Verzerrungstensor (*strain tensor*) bezeichnet, wobei $\varepsilon_{xx}$ dessen erste Komponente bedeutet.

Bei Kristallgittern ist die Deformation $\varepsilon_{xx}$ dabei folgendermaßen definiert:

$$\varepsilon_{xx} = \frac{\text{Gitterkonstante a} - \text{Gitterkonstante a}_0}{\text{Gitterkonstante a}_0}$$

wobei a die tatsächliche Gitterkonstante im Kristall und $a_0$ die theoretisch ideale Gitterkonstante darstellt, wobei für $a_0$

typischerweise ein Literatur-Wert von 3.1892±0.00004Å angenommen werden kann (nach V. Darakchieva, B. Monemar, A. Usui, M. Saenger, M. Schubert, Journal of Crystal Growth 310 (2008) 959-965).

Demgemäß kann durch Aufwachsen von Kristallschichten unter extrinsischem Stress auf die tatsächlich vorliegenden Kristallgitterkonstanten Einfluss genommen werden. Beispielsweise kann durch extrinsischen Stress eine kompressive Spannung auf den wachsenden Kristall übertragen werden, wodurch Gitterkonstanten in der Wachstumsebene gegenüber Wachstum ohne Stress verkürzt werden. Dadurch baut sich innerhalb des Kristalls steuerbar und gezielt intrinsischer Stress auf, der die zuvor genannten Eigenschaften Deformation und Verspannung bei fortgesetztem oder nachfolgendem Kristallwachstum günstig beeinflusst. Solche Template eignen sich hervorragend als Ausgangsprodukte für das Aufwachsen weiterer epitaxialer Schichten des III-N-Systems, insbesondere zum Herstellen von dicken III-N-Schichten und -Boules (Massivkristalle). Erfindungsgemäß weisen III-N-Kristalle von Templaten der vorliegenden Erfindung einen $\varepsilon_{xx}$-Wert in einem Bereich < 0 auf.

Im Folgenden wird eine Zusammenstellung von Punkten angegeben, die Gegenstände, Weiterbildungen und besondere Merkmale der vorliegenden Offenbarung beschreibt:

1. Verfahren zur Herstellung eines Templats, welches ein Substrat und mindestens eine III-N-Kristallschicht umfasst, wobei III mindestens ein Element der dritten Hauptgruppe des Periodensystems, ausgewählt aus Al, Ga und In, bedeutet, wobei das Verfahren die folgenden Schritte umfasst:

a) Bereitstellen eines Substrats,

b) Durchführen von Wachstum eines kristallinen III-N-Materials auf dem Substrat bei einer ersten Kristallwachstumstemperatur,

c) Verändern der Temperatur auf eine zweite Temperatur, die gegenüber der ersten Kristallwachstumstemperatur verändert ist, bei der jedoch Kristallwachstum stattfinden kann,

d) Fortsetzen von Kristallwachstum zum Bilden von III-N-Kristall in einem gegenüber der ersten Wachstumstemperatur veränderten Bereich , ohne in diesem Schritt d) In zuzugeben

mit der Maßgabe, dass die zweite Temperatur im Schritt c) niedriger ist als die erste Temperatur und im Schritt d) das Kristallwachstum unterhalb der ersten Wachstumstemperatur fortgesetzt wird, wenn das verwendete Substrat einen höheren thermischen Ausdehnungskoeffizienten aufweist als der bis Schritt d) zu wachsende III-N-Kristall,

oder dass die zweite Temperatur im Schritt c) höher ist als die erste Temperatur und im Schritt d) das Kristallwachstum oberhalb der ersten Wachstumstemperatur fortgesetzt wird, wenn das verwendete Substrat einen niedrigeren thermischen Ausdehnungskoeffizienten aufweist als der bis Schritt d) zu wachsende III-N-Kristall.

2. Verfahren zur Herstellung von III-N-Einkristall, wobei III mindestens ein Element der dritten Hauptgruppe des Periodensystems, ausgewählt aus der Gruppe von Al, Ga und In, bedeutet, wobei das Verfahren die folgenden Schritte umfasst:

a) Bereitstellen eines Substrats,

b) Durchführen von Wachstum eines kristallinen III-N-Materials auf dem Substrat bei einer ersten Kristallwachstumstemperatur,

c) Verändern der Temperatur auf eine zweite Temperatur, die gegenüber drer ersten Kristallwachstumstemperatur verändert ist, bei der jedoch Kristallwachstum stattfinden kann,

d) Fortsetzen von Kristallwachstum zum Bilden von III-N-Kristall in einem gegenüber der ersten Wachstumstemperatur veränderten Bereich, ohne in diesem Schritt d) In zuzugeben,

mit der Maßgabe, dass die zweite Temperatur im Schritt c) niedriger ist als die erste Temperatur und im Schritt d) das Kristallwachstum unterhalb der ersten Wachstumstemperatur fortgesetzt wird, wenn das verwendete Substrat einen höheren thermischen Ausdehnungskoeffizienten aufweist als der bis Schritt d) zu wachsende III-N-Kristall,

oder dass die zweite Temperatur im Schritt c) höher ist als die erste Temperatur und im Schritt d) das Kristallwachstum oberhalb der ersten Wachstumstemperatur fortgesetzt wird, wenn das verwendete Substrat einen niedrigeren thermischen Ausdehnungskoeffizienten aufweist als der bis Schritt d) zu wachsende III-N-Kristall,

e) zusätzliches epitaxiales Kristallwachstum zum Bilden von III-N-Kristall bei einer Kristallwachstumstemperatur, die unabhängig von den genannten ersten und zweiten Temperaturen gewählt werden kann, wobei gegebenenfalls in diesem Schritt e) In zugegeben werden kann, und

f) optional Trennen von gebildeten III-N-Einkristall und Substrat.

3. Verfahren gemäß Punkt 1 oder 2, dadurch gekennzeichnet, dass in den Schritten b) bis d) MOVPE als Aufwachsmethode verwendet wird.

4. Verfahren gemäß einem der vorangehenden Punkte, dadurch gekennzeichnet, dass in Schritt c) die Veränderung, d.h. Absenkung oder Erhöhung der Temperatur eine Temperaturdifferenz $\Delta T$ $(T_1-T_2)$ im Reaktor festlegt, deren Betrag bei mindestens 10 °C, insbesondere im Bereich von 10-100 °C, vorzugsweise bei mindestens 20 °C, weiter bevorzugt im Bereich von 20-50 °C, noch weiter bevorzugt im Bereich von 25-40 °C und besonders bevorzugt bei 30 °C liegt.

5. Verfahren gemäß einem der vorangehenden Punkte, dadurch gekennzeichnet, dass die erste Wachstumstemperatur im Reaktor im Bereich von 1000-1100°C, bevorzugt bei 1020-1080°C, mehr bevorzugt bei etwa 1040°C liegt.

6. Verfahren gemäß einem der vorangehenden Punkte, dadurch gekennzeichnet, dass in Schritt b) III-N-Kristallite vertikal und lateral wachsen.

7. Verfahren gemäß einem der vorangehenden Punkte, dadurch gekennzeichnet, dass in Schritt c) die Temperatur zum Zeitpunkt der einsetzenden Kristallitkoaleszenz verändert wird, und dass im Anschluss an die besagte Temperaturveränderung auf den koaleszierten III-N-Kristalliten ein epitaxiales Kristallwachstum folgt, je nachdem wie festgelegt im Bereich unterhalb oder oberhalb der ersten Wachstumstemperatur.

8. Verfahren gemäß einem der vorangehenden Punkte, dadurch gekennzeichnet, dass in Schritt c) die Temperatur abgesenkt wird auf eine zweite Temperatur im Reaktor im Bereich von 950-1050°C, bevorzugt bei 990-1030 °C, mehr bevorzugt bei etwa 1010°C.

9. Verfahren gemäß einem der vorangehenden Punkte, dadurch gekennzeichnet, dass in Schritt d) die Wachstumstemperatur unterhalb der ersten Wachstumstemperatur im Bereich von 950-1075 °C, bevorzugt von 975-1050 °C, mehr bevorzugt von 990 bis 1030 °C liegt.

10. Verfahren gemäß einem der vorangehenden Punkte, dadurch gekennzeichnet, dass nach der Temperaturabsenkung die Wachstumstemperatur für das weitere Wachstum in Schritt d) im Wesentlichen konstant gehalten wird.

11. Verfahren gemäß einem der vorangehenden Punkte, dadurch gekennzeichnet, dass während einer Wachstumsphase im Schritt d), d.h. beim Bilden einer III-N-Materialschicht, bei Wachstumstemperatur eine gegebene Krümmung der Wachstumsoberfläche, kontinuierlich oder intermittierend, abnimmt.

12. Verfahren gemäß einem der vorangehenden Punkte, dadurch gekennzeichnet, dass in Schritt b) eine konkave Krümmung der Wachstumsoberfläche verursacht wird und dass in Schritt c) durch Verändern der Temperatur die Wachstumsoberfläche die konkave Krümmung, im Vergleich zu der Krümmung vor dem Verändern, geringer wird oder die Krümmung beseitigt wird.

13. Verfahren gemäß einem der vorangehenden Punkte, dadurch gekennzeichnet, dass die Krümmungsdifferenz $(K_a-K_e)$ des Templats zu Beginn (Krümmungswert $K_a$) und am Ende (Krümmungswert $K_e$) von Schritt d) ein positives Vorzeichen aufweist.

14. Verfahren gemäß dem vorangehenden Punkt, dadurch gekennzeichnet, dass die Krümmungsdifferenz $(K_a-K_e)$ mindestens 5 km$^{-1}$, weiter bevorzugt mindestens 10 km$^{-1}$ beträgt.

15. Verfahren gemäß dem vorangehenden Punkt, dadurch gekennzeichnet, dass die Krümmungsdifferenz $(K_a-K_e)$ höchstens 50 km$^{-1}$, bevorzugt 20 km$^{-1}$ beträgt.

16. Verfahren gemäß einem der vorangehenden Punkte, dadurch gekennzeichnet, dass nach Abschluss von Schritt d) das Substrat nicht oder im wesentlichen nicht gekrümmt ist oder negativ gekrümmt ist, vorzugsweise die Krümmung $(K_e)$ im Bereich bis maximal 30 km$^{-1}$ liegt.

17. Verfahren gemäß einem der vorangehenden Punkte, dadurch gekennzeichnet, dass nach Abschluss von Schritt d) das Substrat im Wesentlichen nicht gekrümmt ist und dabei die Krümmung $(K_e)$ vorzugsweise im Bereich $\pm30$ km$^{-1}$ liegt.

18. Verfahren gemäß einem der vorangehenden Punkte, dadurch gekennzeichnet, dass die Schritte b) bis d) im Rahmen des Wachstums nur einer einzelnen (d.h. ein und derselben) III-N-Schicht des Templats durchgeführt werden.

19. Verfahren gemäß einem der vorangehenden Punkte, dadurch gekennzeichnet, dass nach Abschluss von Schritt d) eine III-N-Schicht mit einer Dicke im Bereich bis 25 $\mu$m, bevorzugt 0,1-10 $\mu$m, weiter bevorzugt von 2-5 $\mu$m auf das Substrat aufgetragen worden ist.

20. Verfahren zur Herstellung von III-N-Einkristall, wobei III mindestens ein Element der dritten Hauptgruppe des Periodensystems, ausgewählt aus Al, Ga und In, bedeutet, wobei das Verfahren die folgenden Schritte umfasst:

aa) Bereitstellen eines Templats, welches ein Fremdsubstrat und mindestens eine III-N-Kristallschicht umfasst, wobei das Templat im Temperaturbereich eines epitaxialen Kristallwachstums nicht oder im wesentlichen nicht gekrümmt ist oder negativ gekrümmt ist,

bb) Durchführen eines epitaxialen Kristallwachstums von III-N-Kristall bei einer Kristallwachstumstemperatur, bei der das Templat nicht oder im Wesentlichen nicht gekrümmt ist oder negativ gekrümmt ist, wobei vorzugsweise in den Schritten aa) und bb) kein In zugegeben wird, und

cc) optional zusätzliches epitaxiales Kristallwachstum zum Bilden von III-N-Kristall bei einer Kristallwachstumstemperatur, die unabhängig von der genannten Kristallwachstumstemperatur des Schritts bb) gewählt werden kann, wobei gegebenenfalls in diesem Schritt cc) Indium zugegeben werden kann, und
dd) ferner optional Trennen von III-N-Einkristall und Fremdsubstrat.

21. Verfahren gemäß Punkt 20, dadurch gekennzeichnet, dass nach Abschluss von Schritt bb) im die Bedingung von "im wesentlichen nicht gekrümmt" oder "negativ gekrümmt" bedeutet, dass die Krümmung ($K_e$) im Bereich bis maximal 30 km$^{-1}$ liegt.

22. Verfahren gemäß Punkt 21, dadurch gekennzeichnet, dass das Templat im Wesentlichen nicht gekrümmt ist und dabei die Krümmung ($K_e$) vorzugsweise im Bereich $\pm$30 km$^{-1}$ liegt.

23. Verfahren gemäß einem der vorangehenden Punkte, dadurch gekennzeichnet, dass das in Schritt a) bzw. aa) verwendete Substrat ein Fremdsubstrat mit höherem thermischen Ausdehungskoeffizienten als der zu wachsende III-N-Kristall, ausgewählt aus der LiAlO$_2$ und Saphir umfassenden Gruppe, bevorzugt Saphir ist.

24. Verfahren gemäß einem der vorangehenden Punkte, dadurch gekennzeichnet, dass das in Schritt a) bzw. aa) verwendete Substrat ein Fremdsubstrat mit niedrigerem thermischen Ausdehungskoeffizienten als der zu wachsende III-N-Kristall, ausgewählt aus der SiC und Si umfassenden Gruppe.

25. Verfahren gemäß einem der Punkte 20 bis 24, dadurch gekennzeichnet, dass in Schritt aa) die mindestens eine III-N-Kristallschicht kein Indium enthält, und/oder dass in Schritt bb) beim epitaxialen Kristallwachstum von III-N-Kristall kein Indium zugegeben wird.

26. Verfahren gemäß einem der Punkte 20 bis 25, dadurch gekennzeichnet, dass das im Schritt aa) bereitgestellte Templat durch ein Verfahren gemäß einem der Punkte 1 bis 19 hergestellt wurde.

27. Verfahren gemäß einem der Punkte 20 bis 26, dadurch gekennzeichnet, dass das im Schritt aa) bereitgestellte Templat dadurch hergestellt wurde, dass während des Wachstums, oder in einer intermittierenden Zwischenstufe zu Beginn oder zwischen Beginn und Fortsetzung des Wachstums, eines kristallinen III-N-Materials für die besagte III-N-Kristallschicht auf dem Substrat ein Maskenmaterial als Zwischenschicht auf dem Substrat, welches gegebenenfalls eine III-N-Nukleationsschicht aufweist, oder im kristallinen III-N-Material selbst in einem maximalen Abstand vom Substrat oder der gegebenenfalls vorgesehenen III-N-Nukleationsschicht von 300nm, bevorzugt bei einem Abstand von unter 100nm, weiter bevorzugt bis maximal 50nm, abgeschieden wird und danach das Wachstum des kristallinen III-N-Materials für die besagte III-N-Kristallschicht fortgesetzt wird.

28. Verfahren gemäß Punkt 27, dadurch gekennzeichnet, dass das Maskenmaterial ein von Substratmaterial und III-N verschiedenes Material ist, auf dem III-N-Wachstum gehemmt, gestört oder verhindert ist, wobei das Maskenmaterial vorzugsweise ausgewählt wird aus der Gruppe, die aus Si$_x$N$_y$ (worin x und y jeweils unabhängig voneinander positive Zahlen bedeuten, die zu stöchiometrischen oder unstöchiometrischen SiN-Verbindungen führen; insbesondere Si$_3$N$_4$), TiN, Al$_x$O$_y$ (worin x und y jeweils unabhängig voneinander positive Zahlen bedeuten, die zu stöchiometrischen oder unstöchiometrischen AlO-Verbindungen führen; insbesondere Al$_2$O$_3$), Si$_x$O$_y$ (worin x und y jeweils unabhängig voneinander positive Zahlen bedeuten, die zu stöchiometrischen oder unstöchiometrischen SiO-Verbindungen führern; insbesondere SiO$_2$) WSi, und WSiN besteht.

29. Verfahren gemäß Punkt 27 oder 28, dadurch gekennzeichnet, dass die Zwischenschicht des als eine einzige Schicht ausgebildet wird, und/oder dass die Dicke der Zwischenschicht im Nanometer- oder im Subnanometer-Bereich, zum Beispiel unter 5 nm, mehr bevorzugt unter 1 nm, insbesondere bis unter einer Monolage (d.h. 0,2 bis 0,3 nm oder weniger) ausgebildet ist.

30. Verfahren gemäß einem der Punkte 20 bis 29, dadurch gekennzeichnet, dass das im Schritt aa) bezeichnete Krümmungsverhalten des bereitgestellten Templats im Rahmen des Wachstums nur einer einzelnen III-N-Schicht des Templats eingestellt wurde.

31. Verfahren gemäß einem der vorangehenden Punkte, dadurch gekennzeichnet, dass das Startsubstrat in Schritt a) bzw. aa) eine polierte Oberfläche aufweist.

32. Verfahren gemäß einem der vorangehenden Punkte, dadurch gekennzeichnet, dass das Startsubstrat in Schritt a) bzw. aa) eine durch Lithographie oder nasschemisches Ätzen oder trockenchemisches Ätzen (z.B. ICP) strukturierte Oberfläche aufweist.

33. Verfahren zur Herstellung von III-N-Einkristall gemäß einem der vorangehenden Punkte, dadurch gekennzeichnet, dass das Kristallwachstum mindestens im Schritt e) des Punktes 2 oder im optionalen Schrittes cc) des Punktes 20, gegebenenfalls in allen Kristallwachstumsschritten, mittels HVPE durchgeführt wird.

34. Verfahren zur Herstellung von III-N-Einkristall gemäß einem der Punkte 2 bis 33, dadurch gekennzeichnet, dass nach Abschluss des epitaxialen Wachstums III-N-Einkristalle gewachsen werden mit Schichtdicken von mindestens 0,5 mm, bevorzugt von mindestens 1 mm, weiter bevorzugt von mindestens 5 mm, insbesondere von mindestens 7 mm und am meisten bevorzugt von mindestens 1 cm.

35. Verfahren zur Herstellung von III-N-Einkristall gemäß einem der vorangehenden Punkte, dadurch gekennzeichnet, dass mindestens eine und gegebenenfalls weitere GaN-, AlN-, AlGaN-, InN-, InGaN-, AlInN- oder AlInGaN-Schicht(en) zur Herstellung entsprechend dickerer III-N-Schichten oder III-N-Einkristalle aufgebracht werden.

36. Verfahren zur Herstellung von III-N-Einkristall gemäß einem der vorangehenden Punkte, dadurch gekennzeichnet, dass die III-N-Kristallschicht auf dem Substrat sowie der darauf epitaxial aufgewachsene III-N-Kristall aus demselben III-N Material bestehen.

37. Verfahren zur Herstellung von III-N-Einkristall gemäß einem der vorangehenden Punkte, dadurch gekennzeichnet, dass bei der III-N-Kristallschicht auf dem Substrat sowie dem darauf epitaxial aufgewachsenen III-N-Kristall für die III-Komponente kein Austausch vorgenommen wurde.

38. Verfahren zur Herstellung von III-N-Einkristall gemäß einem der vorangehenden Punkte, dadurch gekennzeichnet, dass die III-N-Kristallschicht auf dem Substrat sowie der darauf epitaxial aufgewachsene III-N-Kristall jeweils ein binäres System bilden.

39. Verfahren zur Herstellung von III-N-Einkristall gemäß einem der Punkte 2 bis 38, dadurch gekennzeichnet, dass das optionale Trennen von III-N-Einkristall und Substrat durch Selbstablösung geschieht, vorzugsweise beim Abkühlen von einer Kristallwachstumstemperatur.

40. Verfahren zur Herstellung von III-N-Einkristall gemäß einem der Punkte 2 bis 38, dadurch gekennzeichnet, dass das optionale Trennen von III-N-Einkristall und Substrat durch Abschleifen, Absägen oder einen lift-off-Prozess geschieht.

41. Verfahren zur Herstellung von III-N-Einkristall gemäß einem der vorangehenden Punkte, dadurch gekennzeichnet, dass das Substrat und die mindestens eine III-N-Kristallschicht so gebildet sind, dass die III-N-Kristallschichtoberfläche bei Raumtemperatur eine konvexe Krümmung aufweist.

42. Verfahren zur Herstellung von III-N-Einkristall gemäß einem der vorangehenden Punkte, dadurch gekennzeichnet, dass der III-N-Einkristall im Temperaturbereich eines epitaxialen Kristallwachstums einen Wert $\varepsilon_{xx} \leq 0$, bevorzugt einen Wert $\varepsilon_{xx} < 0$ aufweist.

43. Verfahren zur Herstellung von III-N-Einkristall gemäß einem der vorangehenden Punkte, dadurch gekennzeichnet, dass der III-N-Einkristall bei Raumtemperatur einen Radius im Bereich von -4 bis -6 m aufweist.

44. Verfahren zur Herstellung von III-N-Einkristall gemäß einem der vorangehenden Punkte, dadurch gekennzeichnet, dass der III-N-Einkristall bei Raumtemperatur eine kompressive Spannung von $\sigma_{xx} < -0,70$ GPa aufweist.

45. Verfahren zur Herstellung von III-N-Einkristall gemäß einem der vorangehenden Punkte, dadurch gekennzeichnet, dass der III-N-Einkristall, wenn als Substrat Saphir einer Dicke von 430 $\mu$m und als III-N-Kristallschicht des Templats GaN einer Dicke von 3,5 $\mu$m verwendet wird, bei Raumtemperatur eine Krümmung $K_T < -170$ km$^{-1}$, bevorzugt im Bereich von $-170 > K_T > -250$ km$^{-1}$ aufweist, wobei bei Verwendung oder Einstellung anderer Schichtdicken der Krümmungswert in Abhängigkeit der jeweiligen Schichtdicken analog der Stoney-Gleichung im folgenden Bereich liegt:

$$K_T(d_{GaN}; d_{Saphir}) = K_T(3,5\mu m; 430\mu m) \times (430\mu m/d_{Saphir})^2 \times (d_{GaN}/3,5\mu m).$$

46. Verfahren zur Herstellung von III-N-Einkristall gemäß einem der vorangehenden Punkte, dadurch gekennzeichnet, dass der III-N-Einkristall bei Raumtemperatur einen Wert $\varepsilon_{xx} < -0,002$, bevorzugt einen Wert $\varepsilon_{xx}$ im Bereich von -0,002 bis -0,004 aufweist.

47. Verfahren zur Herstellung von III-N-Kristallwafern, wobei III mindestens ein Element der dritten Hauptgruppe des Periodensystems ausgesucht aus der Gruppe von Al, Ga und In bedeutet und das Verfahren die folgenden Schritte umfasst:

    a) Durchführung eines Verfahrens gemäß den Punkten 2 bis 46 zum Bilden eines III-N-Einkristalls, und
    b) Vereinzeln des Einkristalls zum Bilden von Wafern, gegebenenfalls einer Vielzahl von Wafern.

48. III-N-Einkristall anhaftend an einem Fremdsubstrat, wobei III mindestens ein Element der dritten Hauptgruppe des Periodensystems, ausgewählt aus der Gruppe von Al, Ga und In, bedeutet, dadurch gekennzeichnet, dass der III-N-Einkristall durch einen oder beide der folgenden Werte (i)/(ii) der Deformation $\varepsilon_{xx}$ definiert ist:

    (i) bei Raumtemperatur liegt der $\varepsilon_{xx}$-Wert im Bereich < 0, bevorzugt liegt der $\varepsilon_{xx}$-Wert im Bereich $\varepsilon_{xx} \leq -0,002$;
    (ii) in einem Temperaturbereich, bei dem ein epitaxiales Kristallwachstum von irgendeinem Material und insbesondere von III-N-Material stattfinden würde, ist der $\varepsilon_{xx}$-Wert $\leq 0$, bevorzugt ist der $\varepsilon_{xx}$-Wert < 0.

49. III-N-Einkristall gemäß Punkt 48, dadurch gekennzeichnet, dass $\varepsilon_{xx}$ bei Raumtemperatur im Bereich von -0,002 bis -0,004 liegt.

50. III-N-Einkristall gemäß Punkt 48 oder 49, in Form eines Templats mit einer Schichtdicke des III-N-Einkristalls im Bereich bis maximal 25 $\mu$m, bevorzugt von 0,1 bis 10 $\mu$m, weiter bevorzugt von 2 bis 5 $\mu$m.

51. III-N-Einkristall gemäß einem der vorangehenden Punkte, dadurch gekennzeichnet, dass der III-N-Einkristall bei Raumtemperatur eine kompressive Spannung von $\sigma_{xx}$<-0,70 GPa aufweist.

52. III-N-Einkristall gemäß einem der vorangehenden Punkte, dadurch gekennzeichnet, dass das Fremdsubstrat aus der aus SiC, Si, LiAlO$_2$ und Saphir bestehenden Gruppe ausgewählt ist, bevorzugt Saphir umfasst und weiter bevorzugt aus Saphir besteht.

53. III-N-Einkristall gemäß einem der vorangehenden Punkte mit Saphir als Fremdsubstrat und GaN als III-N-Einkristall, dadurch gekennzeichnet, dass wenn der Saphir eine Dicke von 430 $\mu$m und die GaN-Schicht eine Dicke von 3,5 $\mu$m aufweist, bei Raumtemperatur eine Krümmung $K_T$<-170 km$^{-1}$, bevorzugt im Bereich von -170>$K_T$>-250 km$^{-1}$ vorliegt, wobei beim Vorliegen anderer Schichtdicken des Saphir und/oder der GaN-Schicht der Krümmungswert in Abhängigkeit der jeweiligen Schichtdicken analog der Stoney-Gleichung im folgenden Bereich liegt: $K_T(d_{GaN};d_{Saphir})=K_T(3,5\mu m;430\mu m)\times(430\mu m/d_{Saphir})^2\times(d_{GaN}/d3,5\mu m)$.

54. III-N-Einkristall gemäß einem der Punkte 46 bis 51, dadurch gekennzeichnet, dass III = Ga bedeutet und der Kristall in Wachstumsrichtung eine Gitterkonstante im Bereich von a < 0,318926 nm, beispielsweise im Bereich von 0,31829 nm < a < 0,318926 nm aufweist.

55. III-N-Einkristall gemäß einem der vorangehenden Punkte, dadurch gekennzeichnet, dass das Fremdsubstrat entfernt ist.

56. III-N-Einkristall gemäß einem der Punkte 48 bis 54, dadurch gekennzeichnet, dass der Kristall nach einem der Verfahren gemäß der Punkte 2 bis 46 hergestellt wurde.

57. Verwendung eines III-N-Einkristalls oder Templats gemäß einem der Punkte 48 bis 56 zur Herstellung von dickeren III-N-Schichten oder III-N-Kristallbouls bzw. -Massivkristallen, die optional danach in einzelne III-N-Wafer vereinzelt werden.

58. Verwendung eines III-N-Einkristalls oder Templats gemäß einem der Punkte 48 bis 56 zur Herstellung von Halbleiterbauelementen oder elektronischen und optoelektronischen Bauelementen.

59. Verwendung gemäß Punkt 58 zur Herstellung von Leistungsbauelementen, Hochfrequenzbauelementen, lichtemittierenden Dioden und Lasern.

KURZBESCHREIBUNG DER FIGUREN

| | |
|---|---|
| Fig. 1 | zeigt schematisch unterschiedliche Stufen des Aufwachsprozesses zum Bilden eines III-N-Templats gemäß einer Ausführungsform der vorliegenden Erfindung; |
| Fig. 2 | zeigt die Veränderung der Krümmung der Wachstumsoberfläche je nach Verfahrensstufe (die Ziffern 1 bis 6 entsprechen dabei den Stufen (i) bis (vi) der Figur 1) und jeweils angewandter Temperatur, am Beispiel der Abscheidung von GaN auf Saphir gemäß einer möglichen Ausführungsform; |
| Fig. 3 | veranschaulicht zeitliche Temperatur-, Reflexions- und Krümmungsverläufe beim beispielhaften Wachstum von GaN auf Saphir gemäß einer Ausführungsform der vorliegenden Erfindung |
| Fig. 4 | veranschaulicht zeitliche Temperatur-, Reflexions- und Krümmungsverläufe beim beispielhaften Wachstum von GaN auf Si oder SiC gemäß einer alternativen Ausführungsform der vorliegenden Erfindung; und |
| Fig. 5 | veranschaulicht zeitliche Temperatur-, Reflexions- und Krümmungsverläufe bei herkömmlichem Wachstum von GaN auf Saphir. |
| Fig. 6 | zeigt schematisch weitere Ausführungsformen, mit denen alternativ Template bereitgestellt werden können, deren Spannung gezielt und quantitativ genau eingestellt werden können, indem zu jeweils passenden Stufen des Aufwachsprozesses zum Bilden von III-N-Templaten eine Zwischenschicht mit Maskenmaterial vorgesehen und in der richtigen Lage positioniert wird; |
| Fig. 7A und 7B | zeigen die Veränderung der Krümmung der Wachstumsoberfläche hauptsächlich in Abhängigkeit von Vorsehen und Lage/Positionierung einer Zwischenschicht mit Maskenmaterial gemäß unterschiedlichen möglichen Ausführungsformen der vorliegenden Erfindung, im Vergleich zu Vergleichsbeispielen; und |
| Fig. 7C | zeigt die Ergebnisse bezüglich Krümmung der Wachstumsoberfläche, wenn die gemäß Fig. 7A und 7B definierten Template einem weiteren III-N (GaN)-Schichtwachstum zur Herstellung dickerer Schichten unterzogen werden, im Vergleich zu Vergleichsbeispielen. |

Ohne die vorliegende Erfindung damit einzuschränken, soll die nachfolgend detaillierte Beschreibung der Figuren, Gegenstände, Weiterbildungen und besondere Merkmale die Erfindung anschaulich darstellen und besondere Ausführungsformen detaillierter beschreiben.

Im Verfahren zur Herstellung von III-N-Startsubstraten wurde überraschenderweise gefunden, dass Template, die ein Fremdsubstrat und mindestens eine III-N-Kristallschicht umfassen, wobei III mindestens ein Element der dritten Hauptgruppe des Periodensystems, ausgewählt aus Al, Ga und In, bedeutet, hergestellt werden können, die das Wachstum von III-N-Einkristallen mit herausragenden Eigenschaften erlauben.

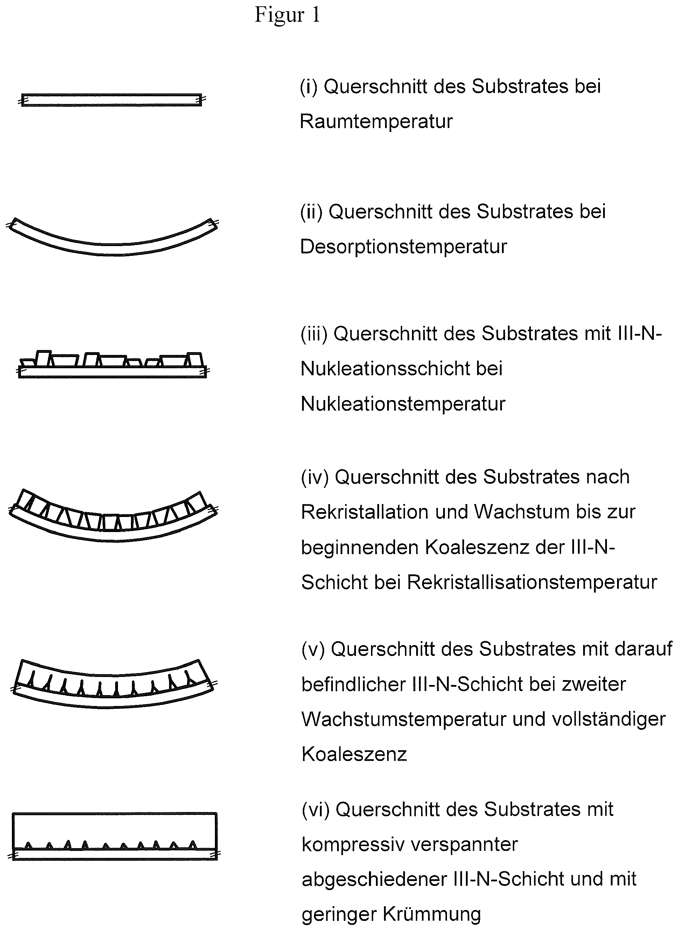

In einer ersten Ausführungsform wird für die Herstellung eines solchen Templats zunächst ein Substrat bereitgestellt. Ein geeignetes Substrat kann ausgewählt werden aus einer Gruppe, die aus einem Homo- oder Hetero-Startsubstrat, einem Startsubstrat mit einer Schicht von aufgewachsenen III-N-Kristalliten, sowie einem Ausgangssubstrat mit darauf gebildeten Strukturen, zum Beispiel bestimmter vorbereiteter III-N-Strukturen und/oder Maskenstrukturen, besteht. Gemäß einer in Figur 1 gezeigten Ausführungsform der vorliegenden Erfindung umfasst das erfindungsgemäße Verfahren das Bereitstellen des Substrats mit Schritten (i) bis (iii). Demgemäß wird zunächst ein Startsubstrat (i) bereitgestellt, welches einem Desorptionsschritt (ii) und einem Nukleationsschritt (iii) unterzogen wird.

Für die Bereitstellung eines Startsubstrats eignet sich ein Fremdsubstrat, das aus SiC, Silicium, LiAlO$_2$ oder Saphir, besonders bevorzugt aus Saphir gebildet ist. Bevorzugt wird ein c-planes Saphirsubstrat verwendet mit einer Verkippung nach (1-100) oder (11-20) um 0,1-0,5° und einseitiger epi-ready-Politur und polierter und/oder vorzugsweise geläppter Rückseite. Eine weitere Ausführungsform sieht vor, dass das Startsubstrat eine durch Lithographie oder nasschemische oder trockenchemisches Ätzen (z.B. ICP) strukturierte Oberfläche aufweist. Die Verwendung eines Fremdsubstrats als Startsubstrat ist von besonderem Nutzen, da das Material des Fremdsubstrats und das aufgewachsene III-N-Material unterschiedliche thermische Ausdehnungskoeffizienten aufweisen, sodass bei Temperaturveränderungen eine Krümmung des Substrats, im speziellen der Wachstumsoberfläche, bewirkt wird und sich dies als Ausgangssituation für das erfindungsgemäße Verfahren besonders eignet. Jedoch kann für die vorliegende Erfindung auch als Startsubstrat ein Homo-Substrat verwendet werden, wobei in diesem Fall eine Krümmung zum Beispiel durch den Temperaturgradienten innerhalb des Startsubstrates eingebracht werden kann. Eine weitere Möglichkeit besteht darin, dass ein Homo-Startsubstrat verwendet wird, auf dem nachfolgend eine - ggf. strukturierte - Fremdmaskierschicht aufgebracht wird, die bei Temperaturveränderung zu einer Veränderung der Krümmung des Substrates führten kann. Eine weitere Möglichkeit der Bereitstellung eines geeigneten Startsubstrats kann die Bildung von Zwischenschichten oder Zwischenstrukturen, die eine spätere Ablösung vom Ausgangssubstrat unterstützen können, und/oder die Bildung eines sogenannten GaN-"Nanorasens" einschließen, bei dem man von einem Substrat mit darauf gebildeter GaN-Komplianz-Sschicht mit Nanosäulenstruktur ausgeht wie beispielsweise in WO2006035212A1, WO2008096168A1, WO2008087452A1, EP2136390A2 und WO2007107757A2 beschrieben.

Das Startsubstrat kann gegebenenfalls weiter vorbehandelt werden. Wie in Figur 1(ii) dargestellt, wird bevorzugt mit dem bereitgestellten Startsubstrat ein Desorptionsschritt durchgeführt. In diesem Desorptionsschritt können zum Beispiel Kohlenwasserstoffreste, aber auch andere flüchtige Verunreinigungen vom Startsubstrat oder strukturiertem oder anders vorbehandeltem Substrat entfernt werden. Während des Desorptionsschritts wird das Startsubstrat im Verfahren auf eine erhöhte Temperatur aufgeheizt, vorzugsweise auf eine Temperatur von 1.000 bis 1.200°C, weiter bevorzugt auf eine Temperatur von 1.050 bis 1.150°C, z.B. ungefähr um 1.090°C. Dabei wird das Startsubstrat aufgrund des Temperaturgradienten innerhalb des Substrats, etwa aufgrund einer gerichteten Aufheizung (typischerweise z.B. durch ein Heizen von der Substratseite des Substrathalters bzw. der - ablage aus, die der Wachstumsoberfläche entgegengesetzt ist), einer Verbiegung unterworfen, typischerweise mit einer negativen Verbiegung (konkav) bezüglich der Oberfläche, auf der nachfolgend das III-N-Material aufgetragen wird (vgl. Fig. 1). Der Desorptionsschritt kann ferner eine Nitridierung mit Ammoniak umfassen. Ein weiterer optionaler Schritt besteht darin, dass nach erfolgter Desorption die Temperatur abgesenkt wird, beispielsweise auf eine Temperatur zwischen 400 und 600 °C, bevorzugt auf eine Temperatur zwischen 450 und 550 °C. Während dieses Abkühlens nimmt die - bevorzugt konkave - Krümmung wieder ab, zum Beispiel auf das Niveau wie zu Beginn des Aufheizens zum Desorptionsschritt.

Das Bereitstellen und Vorbehandeln eines Substrates im Verfahren zur Herstellung eines Templates der vorliegenden Erfindung kann vorzugsweise ferner einen Nukleationsschritt umfassen, bei dem kristallines III-N-Material, speziell winzige III-N-Kristallite auf das Startsubstrat aufgewachsen werden. Dieser Schritt ist schematisch in Figur 1(iii) dargestellt. Das kristalline III-N-Material, speziell die III-N-Kristallite dienen als Kristallisationskeime im späteren Kristallwachstumsverfahrensschritt. III-N-Kristallite weisen Größen von z. B. 1 bis 40 nm mit unregelmäßigen Formen auf, liegen in der Regel ungeordnet auf dem Startsubstrat vor und bilden geeigneterweise zunächst eine nicht zusammenhängende Nukleationsschicht. Dieser Nukleationsschritt findet typischerweise bei Temperaturen von 400 bis 600 °C statt, vorzugsweise von 450 bis 550 °C statt und mehr bevorzugt von 500 bis 540 °C. Weil die Temperatur für eine Nukleation üblicherweise niedriger liegt als diejenige für eine optionale vorangehende Desorption wird die Krümmung aus thermischen Gründen von Schritt (ii) zu (iii) abnehmen. Der Zustand des bereitgestellten Substrats im Schritt (iii) ist daher üblicherweise durch eine relativ geringe Krümmung oder sogar (wie in Fig. 1 schematisch dargestellt) eine fehlende Krümmung zu beschreiben.

Nach dem Bereitstellen eines Substrates, ggf. mit den oben beschriebenen optionalen Maßnahmen wie einem Nukleationsschritt, d.h. nach dem erfindungsgemäßen Schritt a) findet dann eine Temperaturerhöhung statt, auf eine Temperatur, die Kristallwachstum zum Bilden einer III-Schicht ermöglicht. Nach der Definition der vorliegenden Erfindung wird die Temperatur in diesem Stadium als "erste" Kristallwachstumstemperatur des erfindungsgemäßen Schritts b) bezeichnet; diese Definition gilt unabhängig davon, und schließt entsprechend nicht aus, dass zuvor eine erhöhte Prozesstemperatur angewandt wurde, zum Beispiel um Vorbehandlungen, Strukturierungen oder andere Prozessierungen des Ausgangssubstrats durchzuführen. Während des Kristallwachstums bei einer solchen ersten Wachstumstemperatur, gegebenenfalls bereits während des für die Temperaturerhöhung durchgeführten Hochheizens, findet üblicherweise ein Umordnungsprozess von III-N-Keimen statt, wobei kleinere Keime zugunsten größerer Keime verschwinden, Lücken entstehen (spätere Leerstellen oder Voids an der Grenzfläche) und sich der hexagonale Habitus der Keime, der vorher im Nukleationsschritt lediglich angedeutet ist, nun merklich verstärkt. Ein solcher Schritt gemäß der vorliegenden Ausführungsform ist in Figur 1 (iv) dargestellt. Wie insbesondere in Stufe (iv) von Fig. 1 schematisch angedeutet kommt es, infolge Vergrößern oder Koaleszieren der III-N-Keime und im Zuge der sich bildenden Schicht, zu einer Krümmung in Wachstumsrichtung, hier also in einen konkaven Bereich. Die genannte "erste" Wachstumstemperatur im Reaktor liegt dabei in einem Temperaturbereich, bei dem gute Wachstumsbedingungen der jeweiligen III-N-Materialien vorliegen. Im Falle von GaN liegt diese "erste" Wachstumstemperatur beispielsweise im Bereich von 990-1.090°C, bevorzugt bei von 1.020-1060°C, und weiter bevorzugt bei etwa 1.040°C. Im Falle von AlGaN mit einem Al-Anteil von 30% bis zu 90 % liegt diese "erste" Wachstumstemperatur beispielsweise im Bereich von 1.070-1.250°C, bevorzugt bei 1.090-1.130°C, und weiter bevorzugt bei 1.110°C.

Bei dieser ersten Wachstumstemperatur findet ein Wachstum von kristallinem III-N-Material auf dem Substrat statt. Es wachsen III-N-Kristallite vertikal und lateral. Dieses vertikale und laterale Wachstum der III-N-Kristallite ermöglicht es bei ausreichender Kristallisationszeit, dass Koaleszenz der Kristallite eintritt. Während des Kristallwachstums bei der ersten Kristallwachstumstemperatur nimmt die Krümmung des Substrats zu. Die Richtung bzw. das Vorzeichen der Verbiegung/Krümmung wird bezüglich der Oberfläche definiert, auf der nachfolgend das III-N-Material aufgetragen wird.

Eine mit der Temperatur zunehmende Krümmung geschieht im Falle der Verwendung eines Fremdsubstrates ohne weiteres aufgrund der unterschiedlichen thermischen Ausdehnungskoeffizienten von Fremdsubstart und aufwachsenden III-N-Material. Dabei können die Bedingungen, etwa durch Wahl eines verwendeten Fremdsubstrats in Bezug auf das gebildete III-N-Material typischerweise so gewählt werden, dass dabei eine konkave Krümmung zunimmt.

Im Falle der Verwendung eines Homosubstrates tritt eine Krümmung zum Beispiel aufgrund von Temperaturgradienten innerhalb des Substrates auf.

Erfindungsgemäß wird dann zur gezielten und spezifischen Beeinflussung des weiteren Krümmungsverlaufs des Templats die Wachstumstemperatur verändert, entsprechend dem erfindungsgemäßen Schritt c) dieser Ausführungsform. Entsprechend wird bei Verwendung von Saphir oder $LiAlO_2$ als Fremdsubstrat die Temperatur abgesenkt, bei Verwendung von SiC oder Si andererseits wird die Temperatur erhöht. Dies geschieht vorzugsweise bei Beginn oder während der Koaleszenz der wachsenden III-N-Kristallite. Die Temperatur wird jedoch in diesem Schritt maximal nur so weit verändert (d.h. abgesenkt bzw. erhöht), dass weiterhin Kristallwachstum und vorzugsweise epitaxiales Kristallwachstum stattfinden kann. Durch die Temperaturveränderung braucht der Wachstumsprozess nicht unterbrochen werden. Dann findet im Anschluss an die Temperaturänderung auf den koaleszierenden III-N-Kristalliten ein epitaxiales Kristallwachstum in einem zweiten Temperaturbereich statt. Die Veränderung (d.h. Absenkung bzw. Erhöhung) der Temperatur legt eine Temperaturdifferenz $\Delta T$ (erste Wachstumstemperatur T1 minus zweite Wachstumstemperatur T2) im Reaktor fest, deren bei mindestens 10 °C, insbesondere im Bereich von 10-100 °C, vorzugsweise bei mindestens 20 °C, weiter bevorzugt im Bereich von 20-50 °C, noch weiter bevorzugt im Bereich von 25-40 °C und besonders bevorzugt bei 30 °C liegt.

Im Fall des Wachstums von GaN liegt entsprechend eine Temperatur T1 im Reaktor vor, die im Bereich von 990-1.090°C, bevorzugt von 1.020-1060°C, weiter bevorzugt bei etwa 1.040°C liegt. Dementsprechend liegt die zweite Wachstumstemperatur T2 bei Verwendung von zum Beispiel Saphir oder $LiAlO_2$ als Fremdsubstrat bei einer gegenüber der konkret gewählten Temperatur T1 erniedrigten T2 im Bereich von 950-1.050°C, bevorzugt von 990-1.030°C, weiter bevorzugt bei etwa 1.010°C; bei Verwendung von SiC oder Si als Fremdsubstrat andererseits liegt die zweite Wachstumstemperatur T2 gegenüber der konkret gewählten Temperatur T1 erhöht im Bereich von 1.030-1.130°C, bevorzugt von 1050-1.110°C., weiter bevorzugt bei etwa 1.060°C.

Im Fall des Wachstums von AlGaN mit einem Aluminiumanteil bis 30% liegt entsprechend eine Temperatur T1 im Reaktor vor, im Bereich von 1.010-1.110°C, bevorzugt von 1.040-1.080°C, weiter bevorzugt von etwa 1.060°C auf. Dementsprechend liegt die zweite Wachstumstemperatur T2 bei Verwendung von Saphir oder $LiAlO_2$ als Fremdsubstrat bei einer gegenüber der konkret gewählten Temperatur T1 erniedrigten Temperatur im Bereich von 970-1.070°C, bevorzugt von 1.010-1.050°C, weiter bevorzugt von etwa 1.030°C; bei Verwendung von SiC oder Si als Fremdsubstrat andererseits liegt die zweite Wachstumstemperatur T2 gegenüber der konkret gewählten Temperatur T1 erhöht im Bereich von 1.050-1.150°C, bevorzugt von 1060-1.100°C, weiter bevorzugt bei etwa 1.080°C.

Im Fall des Wachstums von AlGaN mit einem Aluminiumanteil von 30% bis 90 % liegt entsprechend eine Temperatur T1 im Reaktor vor, im Bereich von 1.070-1.250°C, bevorzugt von 1.090-1.130°C, weiter bevorzugt bei etwa 1.110°C. Dementsprechend liegt die zweite Wachstumstemperatur T2 bei Verwendung von zum Beispiel Saphir oder $LiAlO_2$ als Fremdsubstrat bei einer gegenüber der konkret gewählten Temperatur T1 erniedrigten Temperatur im Bereich von 1.040-1.220°C, bevorzugt von 1.060-1.100°C, weiter bevorzugt bei etwa 1.080°C; bei Verwendung von SiC oder Si als Fremdsubstrat andererseits liegt die zweite Wachstumstemperatur T2 gegenüber der konkret gewählten Temperatur T1 erhöht im Bereich von 1.080-1.250°C, bevorzugt von 1090-1.150°C, weiter bevorzugt bei etwa 1.120°C.

Während die Krümmung der kristallinen Wachstumsoberfläche, die beim Wachstum von kristallinem III-N-Material auf dem Substrat bei der ersten Kristallwachstumstemperatur vorlag, durch Verändern der Wachstumstemperatur verringert wird, wurde überraschend gefunden, dass beim Fortsetzen des epitaxialen Kristallwachstums im Bereich der zweiten Wachstumstemperatur - d.h. je nach verwendetem Fremdsubstrat unterhalb oder oberhalb der ersten Kristallwachstumstemperatur - die Krümmung der Wachstumsoberfläche nicht wieder zunimmt, sondern mindestens gleich bleibt, bevorzugt weiter kontinuierlich oder intermittierend abnimmt. In einer bevorzugten Ausführungsform verringert sich, bei veränderter Wachstumstemperatur, beim fortgesetzten Wachstum eine konkave Krümmung der Wachstumsoberfläche. Folglich nimmt im Gegensatz zu herkömmlichen Verfahren die Krümmung trotz Wachstums bei der zweiten Wachstumstemperatur ab. Die zweite Wachstumstemperatur kann im vorbeschriebenen, jedoch gegenüber der ersten Wachstumstemperatur veränderten Bereich variieren, oder sie kann an einer bestimmten Temperatur im veränderten Temperaturbereich konstant gehalten werden.

Bezeichnet man den Krümmungswert zu Beginn des Kristallwachstums bei der zweiten Wachstumstemperatur mit $K_a$ ($K_{Anfang}$) und den Krümmungswert zu einem späteren Zeitpunkt und insbesondere gegen Ende des Wachstums der III-N-Schicht des Templats mit $K_e$ ($K_{Ende}$), so weist die Krümmungsdifferenz ($K_a$-$K_e$) des Templats ein positives Vorzeichen auf. Bevorzugt beträgt $K_a$-$K_e$ mindestens 5 km$^{-1}$, weiter bevorzugt mindestens 10 km$^{-1}$. Andererseits sollte diese Krümmungsdifferenz ($K_a$-$K_e$) bevorzugt nicht zu groß sein; so sollte sie vorzugsweise nicht größer als 50 km$^{-1}$, weiter bevorzugt nicht größer als 20 km$^{-1}$ betragen.

Durch Erkennung dieses Verhaltens und der damit verbundenen Zusammenhänge ist es durch das Verfahren der vorliegenden Erfindung möglich, ein eine erste III-N-Schicht umfassendes Templat herzustellen, das bei epitaxialer Wachstumstemperatur keine oder annähernd keine (im wesentlichen keine) Krümmung aufweist oder negativ gekrümmt ist. Der Ausdruck "annähernd keine" bzw. "im wesentlichen keine" Krümmung ist vorzugsweise so definiert, dass der Krümmungswert ($K_e$) bei epitaxialer Wachstumstemperatur im Bereich von maximal $\pm$30 km$^{-1}$ liegt.

Wie aus obiger Beschreibung ersichtlich kann das Krümmungsverhalten erfindungsgemäß bereits im Rahmen des Wachstums einer einzigen (d.h. ein und derselben) III-N-Schicht des Templats vorteilhaft beeinflusst und eingestellt werden. Insbesondere erfolgt die Einflussnahme auf das Krümmungsverhalten im Rahmen der bezeichneten Schritte b) bis d), um eine einzelne III-N-Schicht des Templats entsprechend zu generieren. Schritt d) kann anschließend unabhängig von den beschriebenen Bedingungen durchgeführt werden.

Ohne die vorliegende Erfindung auf eine Theorie festzulegen, wird angenommen, dass in der Phase der Koaleszenz der ersten III-N-Schicht, d.h. dass kurz vor, bei Beginn oder kurz nach der Koaleszenz die Dichte der Keime an der Oberfläche so groß wird, dass eine geschlossene Oberfläche energetisch günstiger ist, wobei durch die stattfindende Ausdehnung der Kristallite in der Wachstumsebene eine tensile Spannung entsteht (Figur 1 (iv)). Durch die beschriebene Veränderung der Temperatur, gegebenenfalls bei Vorliegen eines Fremdsubstrats auch durch den unterschiedlichen thermischen Ausdehnungskoeffizienten des Startsubstrats, werden die koaleszierenden Keime in der Ebene zusammengedrückt, sodass für das nachfolgende III-N-Kristallwachstum ein kompressiv verspanntes Oberflächengitter angeboten wird. Infolge dieser kompressiven Verspannung drückt die aufwachsende III-N-Kristallschicht mit zunehmender Schichtdicke das Fremdsubstrat zurück und bewirkt dadurch eine Abnahme der Krümmung, bevorzugt eine Abnahme der konkaven Krümmung (Figur 1(v)). Dieser Prozess kann bis zum Erreichen einer gewünschten geringen Krümmung oder dem Fehlen jeglicher Krümmung oder sogar dem Generieren einer negativen Krümmung fortgesetzt werden (Figur 1 (vi)).

Durch das Fortsetzen des Wachstums bei der zweiten Kristallwachstumstemperatur wird weiteres III-N-Material epitaxial aufgewachsen. Die III-Komponente des III-N-Materials kann nun grundsätzlich, falls gewünscht, variiert werden, allerdings sollte bevorzugt auf weitere Bedingungen geachtet werden, um die günstige Einflussnahme auf das Krümmungsverhalten nicht zu beeinträchtigen. Insbesondere ist das Einbringen von Indium in dieser Phase des Verfahrens mit Nachteilen behaftet und wird daher bevorzugt unterlassen, da das Wachstum indiumhaltiger Materialien spezielle, besonders niedrige Wachstumstemperaturen erfordert, die zu schlechter Kristallqualität bis hin zu Entmischung führen können. In der Phase des Wachstums bei der "zweiten" Wachstumstemperatur wird also bevorzugt auf die Zugabe von In verzichtet.

Ferner ist es bevorzugt, in dieser Phase das Wachstum im Bereich der zweiten Wachstumstemperatur mit III-N-Materialien durchzuführen, die, wenn in dieser Phase überhaupt Aluminium verwendet werden soll, einen Aluminiumgehalt von maximalen 60% aufweisen, wobei ferner der Anteil (in % der III-Komponenten) im III-N-Material an optional vorhandenem Aluminium vorzugsweise höchstens 30%, weiter bevorzugt höchstens 20%, oder nur im Bereich von 10 bis 0% liegt. Andererseits sind interessante Anwendungen mit Aluminiumanteilen von über 30% ebenfalls sinnvoll, zum Beispiel im Bereich von 50 bis 70%. Ein äußerst hoher Aluminiumanteil von mehr als 70% ist hier zwar grundsätzlich möglich, ist aber eher zu vermeiden, da solche Materialien einen isolierenden Charakter haben und sich nicht gut für die Verwendung in opto-elektronischen Bauelementen eignen.

Weiter bevorzugt ist es, dass sich die III-Komponente, ausgehend von den vorangehenden Schritten etwa bei der Bildung der anfänglichen III-N-Kristallite auf dem Substrat wie oben beschrieben - zum Schritt des Wachstums im Bereich der zweiten Wachstumstemperatur relativ wenig oder besser überhaupt nicht ändert; zum Beispiel ist wünschenswert, dass, wenn die III-Komponente überhaupt variiert wird, die Veränderung der III-Komponente maximal 10 % beträgt. In einer bestimmten Ausführungsform wird die III-Komponenten in dieser Phase des Wachstums im Bereich der zweiten Wachstumstemperatur nicht verändert, und bevorzugt ist das III-N-Material GaN.

In der Phase das Wachstums im Bereich der zweiten Wachstumstemperatur können Schichtdicken geeigneterweise von mindestens 0,1 $\mu$m, zum Beispiel im Bereich von 0,1-10 $\mu$m, bevorzugt von 2-5 $\mu$m auf dem Substrat aufgetragen werden.

In einer bevorzugten Ausführungsform der vorliegenden Erfindung werden alle oben in der ersten Ausführungsform beschriebenen Kristallwachstumsschritte, einschließlich des gegebenenfalls durchgeführten Nukleationsschritts, über metallorganische Gasphasenepitaxie (MOVPE, Metal-Organic Vapor Phase Epitaxy) durchgeführt. Alternativ oder in Kombination können die zuvor beschriebenen Kristallwachstumsschritte jedoch auch über HVPE durchgeführt werden.

Mit dem Abschluss des Kristallwachstums bei der zweiten Wachstumstemperatur wird erfindungsgemäß ein Templat bereitgestellt. Das so erhaltene Templat weist vorteilhafte Eigenschaften und Merkmale auf, die nachfolgend noch weiter beschrieben werden. Es ist als solches ein interessanter kommerzieller Gegenstand, es kann aber auch direkt anschließend oder alternativ indirekt nach Bereitstellung, Lagerung oder Versenden, als Templat im Rahmen unten beschriebener weiterer Schritte weiter verarbeitet werden.

Ein Templat zur Herstellung von weiterem III-N-Einkristall gemäß der vorliegenden Erfindung weist im Temperaturbereich eines epitaxialen Kristallwachstums keine oder annähernd keine Krümmung auf. Wenn als Substrat Saphir einer Dicke ($d_{Saphir}$) von 430 $\mu$m und als III-N-Kristallschicht des Templats GaN einer Dicke ($d_{GaN}$) von 3,5 $\mu$m verwendet oder eingestellt wird, bedeutet die Bedingung "annähernd keine Krümmung" oder "negative Krümmung" bei epitaxialer Kristallwachstumstemperatur, dass das Templat bei Raumtemperatur eine Krümmung $K_{T(3,5\mu m;\ 430\mu m)} < -170$ km$^{-1}$, bevorzugt im Bereich von $-170 > K_T > -250$ km$^{-1}$ aufweist ($K_T$ bedeutet dabei die Krümmung der Oberfläche des Templats bei Raumtemperatur), wobei bei Verwendung oder Einstellung anderer Schichtdicken der Krümmungswert in Abhängigkeit der jeweiligen Schichtdicken analog der folgenden vereinfachten Stoney-Gleichung variieren kann; danach gilt, sofern der Film ($d_{GaN}$) wesentlich dünner ist als das Substrat ($d_{Substrat}$), wobei R= Krümmungsradius und $\varepsilon_{xx}$= Deformation (*strain*)

$$1/R = 6*(d_{GaN}/d^2_{Substrat})*\varepsilon_{xx.}$$

Unter der Annahme einer sehr dünnen Schicht wird $\varepsilon_{xx}$ als konstant angenommen, d.h. wenn sich die Schichtdicken ändern, reagiert das System mit einer Änderung von R (die aus einer Änderung der Krümmung resultierende Änderung von $\varepsilon_{xx}$ wird vernachlässigt). Folglich lassen sich die obigen (teilweise bevorzugten), für den Fall $K_{T(3,5\mu m;\ 430\mu m)}$ geltenden Bereiche des Krümmungswerts bei Raumtemperatur wie folgt umrechnen, wenn andere Werte für $d_{GaN}$ und $d_{Substrat}$ vorliegen: $K_{T(dGaN;dSaphir)}=K_{T(3,5\mu m;430\mu m)}x(430\mu m/d_{Saphir})^2 x(d_{GaN}/3,5\mu m)$

Für ein erfindungsgemäßes Templat bedeutet dies zum Beispiel, dass wenn bei 430 $\mu$m Saphir bei der 3,5-4 $\mu$m dicken GaN-Schicht eine Krümmung von -250 km$^{-1}$ vorliegt, sich bei einem 330 $\mu$m Saphir beim selben Prozess eine Krümmung von -425 km$^{-1}$ ergibt.

In einer weiteren bevorzugten Ausführungsform weist das Templat bei Raumtemperatur für den Fall $d_{Saphir}$=430 $\mu$m und $d_{GaN}$=3,5 $\mu$m einen Krümmungsradius im Bereich von -4 m bis -6 m auf.

Eine weitere Möglichkeit, die Produkt- oder Struktureigenschaften des erfindungsgemäß erhaltenen Templats charakteristisch zu beschreiben, ist durch die Angabe der Deformation der Gitterkonstanten oder der Verspannung möglich.

Die Deformation $\varepsilon_{xx}$ ist dabei folgendermaßen definiert:

$$\varepsilon_{xx} = \frac{\text{Gitterkonstante a} - \text{Gitterkonstante } a_0}{\text{Gitterkonstante } a_0}$$

wobei a die tatsächliche Gitterkonstante im Kristall und $a_0$ die theoretisch ideale Gitterkonstante darstellt.

Röntgen-Verfahren zur Bestimmung absoluter Gitterkonstanten werden in M. A. Moram and M. E. Vickers, Rep. Prog. Phys. 72 (2009) 036502 detailliert diskutiert. Dabei erfolgt die Bestimmung über das Bragg'sche Gesetz

$$n\lambda = 2d_{h\,k\,l}\sin\theta$$

zunächst für die Gitterkonstante c aus einem 2Theta-Scan mit Drei-Achsen-Geometrie in symmetrischen Reflexen wie z.B. 004. Die ideale Gitterkonstante nach V. Darakchieva, B. Monemar, A. Usui, M. Saenger, M. Schubert, Journal of Crystal Growth 310 (2008) 959-965) ist c0= 5.18523±0.00002 Å. Die Bestimmung der Gitterkonstanten a erfolgt dann nach der ebenfalls z.B. in M. A. Moram and M. E. Vickers, Rep. Prog. Phys. 72 (2009) 036502 angegebenen Gleichung

$$\frac{1}{d_{hkl}^2} = \frac{4}{3}\frac{h^2 + k^2 + hk}{a^2} + \frac{l^2}{c^2}$$

aus asymmetrischen Reflexen hkl wie z.B. 105 im 2Theta-scan. Als ideale Gitterkonstante a0 für unverspanntes GaN wird $a0$ = 3.18926±0.00004Å nach V. Darakchieva, B. Monemar, A. Usui, M. Saenger, M. Schubert, Journal of Crystal Growth 310 (2008) 959-965) angenommen.

Zum Hintergrund der Phänomene intrinsische und extrinsische Spannung, u.a. unter Beachtung von Gitterkonstanten, vgl. Hearne et al., Appl.Physics Letters 74, 356-358 (2007).

Ferner können die Eigenschaften auch durch die Verspannung $\sigma_{xx}$ angegeben werden, wobei

$$\sigma_{xx} = M_f \cdot \varepsilon_{XX} \qquad \text{(Hook'sche Formel)}$$

wobei $M_f$ das biaxiale Elastizitätsmodul bedeutet.

Die Bestimmung der Verspannung $\sigma_{xx}$ ist durch Ramanspektroskopie einfach möglich, z.B. wie in I. Ahmad, M. Holtz, N. N. Faleev, and H. Temkin, J. Appl. Phys. 95, 1692 (2004) beschrieben; dort wird das biaxiale Elastizitätsmodul 362 GPa als Wert aus der Literatur herangezogen, wobei ein sehr ähnlicher Wert von 359 GPa aus J. Shen, S. Johnston, S. Shang, T. Anderson, J. Cryst. Growth 6 (2002) 240 zu entnehmen ist; somit ist ein Wert für das biaxiale Elastizitätsmodul $M_f$ von etwa 360 GPa passend und konsistent.

Ein Templat gemäß der vorliegenden Erfindung weist im Temperaturbereich eines epitaxialen Kristallwachstums einen Wert $\varepsilon_{xx}$ < 0. Dieser Wert lässt sich direkt aus einer *in-situ* Messung der Krümmung bestimmen.

Ferner weist ein Templat gemäß der vorliegenden Erfindung bei Raumtemperatur eine kompressive Spannung von $\sigma_{xx}$ < -0,70 GPa auf. Die Deformation $\varepsilon_{xx}$ des Templats bei Raumtemperatur kann einen Wert von $\varepsilon_{xx} \leq$ -0,002 (insbesondere < -0,002), bevorzugt einen Wert im Bereich von -0,002 bis -0,004, annehmen.

Eine geeignete Krümmungsmessvorrichtung, die in Verbindung mit einer Anlage zur Gasphasenepitaxie einsetzbar ist, ist zum Beispiel die Krümmungsmessvorrichtung der Laytec AG, Seesener Strasse, Berlin Deutschland (vgl. z.B. DE102005023302A1 und EP000002299236A1). Diese Krümmungsmessvorrichtungen lassen sich gut mit verfügbaren Anlagen zur Gasphasenepitaxie, wie der MOVPE, HVPE oder MBE (Molecular Beam Epitaxy) kombinieren und ermöglichen zudem eine Messung der Temperatur an der Waferoberfläche.

Demgemäß erhält man nach dem epitaxialen Kristallwachstum im Bereich der zweiten Wachstumstemperatur ein Templat, das aufgrund der oben beschriebenen Eigenschaften dazu geeignet ist, in weiteren epitaxialen Wachstumsschritten Kristalle von besonderer Güte und mit besonderen Merkmalen herzustellen. Das Templat eignet sich somit hervorragend zur Weiterverwendung, kann also als solches bereitgestellt werden, zwischengelagert oder zur Weiterverwendung verschickt, oder kann direkt in einem Gesamtprozess weiterverwendet werden.

So können in einer weiteren Ausführungsform der vorliegenden Erfindung III-N-Einkristalle hergestellt werden, die dadurch gewonnen werden, dass nach dem Kristallwachstumsschritt bei der zweiten Wachstumstemperatur - ohne oder mit Unterbrechung dazwischen - ein zusätzliches epitaxiales Kristallwachstum auf dem erfindungsgemäß erhaltenen Templat zum Bilden von III-N-Kristall bei einer Kristallwachstumstemperatur durchgeführt wird, die unabhängig von den genannten ersten und zweiten Kristallwachstumstemperaturen gewählt werden kann (entsprechend erfindungsgemäßem Schritt e) dieser Ausführungsform). So ist die Wachstumstemperatur im Schritt e) je nach gewünschtem III-N-Material für die zu bildende epitaxiale Schicht frei wählbar und kann daher in einem Bereich liegen, bei dem gute Wachstumsbedingungen der jeweiligen III-N-Materialien vorliegen.

Auch sonstige Bedingungen des Kristallwachstums im erfindungsgemäßen Schritt e) sind nun frei wählbar. So können III-N-Materialien aufgewachsen werden, deren III-Komponente frei wählbar ist. Auch kann nun Indium als III-Komponente enthalten sein. Ferner können Materialien verwendet werden, deren Al-Anteil über 60% liegt.

Entsprechend können im erfindungsgemäßem Schritt e) dieser Ausführungsform mindestens eine (ggf. weitere) GaN-, AlN-, AlGaN-, InN-, InGaN-, AlInN- oder AlInGaN-Schicht zur Herstellung entsprechend dickerer III-N-Schichten oder III-N-Einkristalle aufgebracht werden.

Bevorzugt bilden sowohl die III-N-Kristallschicht auf dem Substrat als der darauf epitaxial aufgewachsene III-N-Kristall ein rein binäres System, z.B. GaN, AlN oder InN, oder die III-N-Kristallschicht auf dem Substrat ist ein rein binäres System, insbesondere GaN, und der darauf epitaxial aufgewachsene III-N-Kristall ist ein frei wählbares binäres oder ternäres III-N-Material, insbesondere wiederum binäres GaN.

Schritt e) kann sich unmittelbar an Schritt d) anschließen, alternativ kann das Verfahren dazwischen unterbrochen werden. Ferner ist es möglich, die Schritte d) und e) in demselben Reaktor durchzuführen, alternativ den Reaktor zwischen den Schritten zu wechseln. Dies ermöglicht es den III-N-Einkristall über eine unterschiedliche Aufwachsmethode aufzuwachsen, als bei der Herstellung des bereitgestellten Templats verwendet wurde, um für die jeweiligen Schritte optimale Bedingungen zu wählen. So wird das zusätzliche epitaxiale Kristallwachstum auf dem erfindungsgemäß hergestellten Templat bevorzugt durch HVPE durchgeführt. Die vorteilhafte Wahl des Schritts e) unter HVPE-Bedingungen ermöglicht hohe Wachstumsraten und entsprechend das Erreichen dickerer Schichten. Es können aber auch alle Schritte des Verfahrens, welche das gesamte Wachstum der III-N-Schicht betrifft, in einer einzigen Anlage mit einer bestimmten Wachstumstechnik, beispielsweise nur mittels HVPE, durchgeführt werden.

Ein weiterer Aspekt ist ein Verfahren zur Herstellung von III-N-Einkristall, wobei III mindestens ein Element der dritten Hauptgruppe des Periodensystems, ausgewählt aus Al, Ga und In, bedeutet, wobei das Verfahren die folgenden Schritte umfasst, vor:

aa) Bereitstellen eines Templats, welches ein Startsubstrat und mindestens eine III-N-Kristallschicht umfasst, wobei das Startsubstrat und die mindestens eine III-N-Kristallschicht so gebildet sind, dass das Templat im Temperaturbereich eines epitaxialen Kristallwachstums nicht oder im wesentlichen nicht gekrümmt ist oder negativ gekrümmt ist, und

bb) Durchführen eines epitaxialen Kristallwachstum von III-N-Kristall bei einer Kristallwachstumstemperatur, bei der das Templat nicht oder im wesentlichen nicht gekrümmt ist oder negativ gekrümmt ist.

Aus den Gründen, die bereits bei den vorangehenden Ausführungsformen beschrieben wurden, ist es auch hier bevorzugt, in den Schritten aa) und bb) kein In zuzugeben. Falls gewünscht kann optional zusätzliches epitaxiales Kristallwachstum angeschlossen werden zum Bilden von III-N-Kristall bei einer Kristallwachstumstemperatur, die unabhängig von der genannten Kristallwachstumstemperaturen des Schritts bb) gewählt werden kann, wobei gegebenenfalls in diesem Schritt des fortgesetzten Wachstums Indium zugegeben werden kann.

Anschließend ist optional ein Trennen der III-N-Einkristall-Schicht(en) vom Startsubstrat möglich.

Dieser Gegenstand der Erfindung geht von dem alternativen Lösungsprinzip aus, die Gefahr von Rissbildungen durch die in den Schritten aa) und bb) festgelegten Voraussetzungen zu minimieren oder ganz zu unterdrücken.

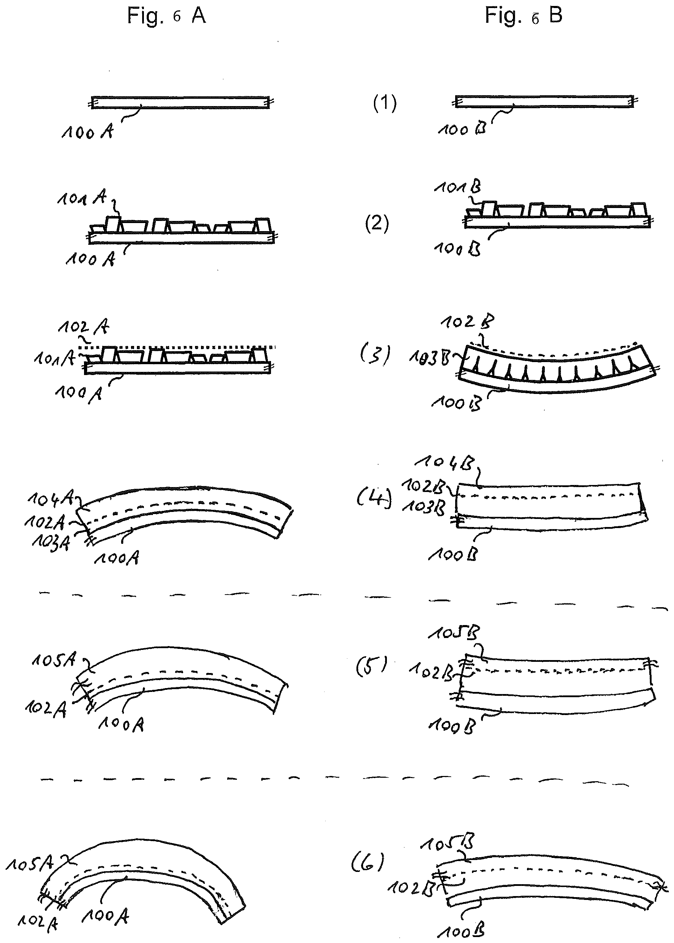

Zur Bereitstellung eines Templats für Schritt aa) kann zum Beispiel auf die obige Beschreibung zum Bilden des erfindungsgemäßen Templats verwiesen werden. So können als alternative und gegebenenfalls kombiniert anzuwendende Möglichkeiten zur Bereitstellung eines Templats für Schritt aa) die oben beschriebene Methode der Temperaturveränderung während des Wachstums bzw. die ebenfalls oben beschriebene Methode der Anwendung einer Maskenmaterial-Zwischenschicht im Rahmen der Bildung der Templat-III-N-Schicht angewandt werden. Während für die erstgenannte Methode auf die obige detaillierte Beschreibung verwiesen werden kann, werden für die zweitgenannte Methode beispielhafte Ausführungsformen schematisch in Fig. 6 gezeigt.

In den Figuren 6A und 6B ist zunächst im gleichen Schritt (1) die Bereitstellung der jeweilige Substrate 100A bzw. 100B gezeigt. Die jeweiligen Substrate können optional wie oben beschrieben vorbehandelt sein, insbesondere können diese jeweils einem Desorptionsschritt und einem Nukleationsschritt unterzogen sein. In einem Nukleationsschritt bildet sich kristalline III-N-Material 101A bzw. 101B, insbesondere winzige III-N-Kristallite auf dem Startsubstrat (vgl. Schritt (2) der Fig. 6A und 6B), was als Kristallisationskeime im späteren weiteren III-N-Kristallwachstum dient. Die weiteren Schritte können variieren, was Zeitpunkt und Position/Lage der Schicht des Maskenmaterials und die daraus resultierenden Konsequenzen anbelangt, wie nun jeweils getrennt in Fig. 6A und Fig. 6B veranschaulicht. Bei der in Fig. 6A gezeigten Ausfuhrungsform wird bereits direkt auf die Nukleationsschicht 101A, noch bevor Koaleszenz der Kristallite eintritt, eine Zwischenschicht aus Maskenmaterial 102A aufgebracht. In einer weiteren (hier nicht speziell dargestellten) Modifikation erfolgt diese Abscheidung der Zwischenschicht nicht direkt auf der Nukleationsschicht, sondern erst nach einer sehr kurzen Phase eines III-N-Wachstums, aber noch sehr nahe im nm-Bereich an der Nukleationsschicht, zum Beispiel in einem Bereich von bis 30nm Abstand. In diesem sehr nah an der Nukleationsschicht gewählten Abstandsbereich laufen die nachfolgenden Schritte praktisch analog der in Fig. 6A gezeigten Form ab. Bei der in Fig. 6B gezeigten Ausführungsform wird auf der Nukleationsschicht 101B zunächst für eine bestimmte, in der Regel nach wie vor relativ kurze Zeit ein III-N-Wachstum durchgeführt, zum Beispiel bis sich eine geringe Dicke von 30nm oder darüber und geeigneterweise bis 300nm oder unter, vorzugsweise bis ca. 100nm, weiter bevorzugt bis ca. 50nm der kristallinen III-N-Schicht 103B gebildet hat, und erst dann wird im entsprechenden Abstand von der Nukleationsschicht des Substrats eine Zwischenschicht aus Maskenmaterial 102B aufgebracht.

Die Abscheidung der bezeichneten Zwischenschicht 102A bzw. 102B geschieht zweckmäßig und vorteilhaft in situ im gleichen Reaktor mit einem Prozess, der mit der Technik zum Wachstum der III-N-Schicht des Templats kompatibel ist. So wird zum Beispiel ein Silangas und Ammoniak in den Reaktor eingeströmt und bei geeignetem Druck und geeigneter Temperatur von zum Beispiel 800 °C bis 1200°C, vorzugsweise etwa 1050 bis 1150°C miteinander zur Reaktion und in Form von $Si_3N_4$ und ggf. weiterer stöchiometrischer oder über- oder unterstöchiometrischer $Si_xN_y$-Zusammensetzungen auf dem vorbereiteten Substrat (100A; 101A) abgeschieden. Der Schritt der Abscheidung anderer Maskenmaterialien als SiN, wie z.B. TiN, $Al_2O_3$, $SiO_2$, WSi, und WSiN, kann ohne weiteres und entsprechend angepasst werden. Die so gebildete Maskenschicht 102A bzw. 102B kann unterschiedliche Formen aufweisen. Sie ist in der Regel sehr dünn, geeigneterweise im Nanometer- oder im Subnanometer-Bereich, zum Beispiel unter 5 nm, mehr bevorzugt unter 1 nm, insbesondere bis unter einer Monolage (d.h. 0,2 bis 0,3 nm oder weniger), und sie kann gleichmäßig auf der Oberfläche verteilt sein und dabei eine geschlossene Schicht bilden, jedoch weist sie alternativ eher mikroskopische/nanostrukturierte Lücken bzw. eine diskontinuierliche Struktur auf (in der Zeichnung schematisch in Form einer gestrichelten Schicht 102A bzw. 102B dargestellt).

Nach Abscheidung der Zwischenschicht mit Maskenmaterial erfolgt unmittelbar darauf das (fortgesetzte) Wachstum einer III-N-Schicht 104A,104B (Stufe (4) in Fig. 6A/6B), bis das Templat am Wachstumsende (Stufe (5) in Fig. 6A/6B) eine III-N-Schicht 105A, 105B mit gewünschter Dicke im Bereich von 0,1-10 $\mu$m, vorzugsweise im Bereich von 3 bis 10 $\mu$m aufweist.

Erfindungsgemäß wird auch gemäß dieser Ausführungsform dafür gesorgt, dass die Charakteristika Krümmung (gemessen an der Wachstumsoberfläche) und/oder Verspannung der III-N-Schicht des Templats günstig beeinflusst und für nachfolgende Prozesse ausgenutzt werden. So wird erfindungsgemäß bewirkt, dass die Krümmung des Templats während des anschließenden weiteren Wachstums einer wachsenden III-N-Schicht 104A bzw. 104B abnimmt, wie in den jeweiligen Schritten (4) von Fig. 6A/6B schematisch gezeigt. Anders als bei einer Situation ohne Abscheidung wird erfindungsgemäß durch die Maskenschicht 102A/102B an geeigneter Lage/Position sogar eine Abnahme der Krümmung erreicht und somit eine Krümmungsdifferenz $K_a$-$K_e \geq 0$ beachtet.

Durch das erfindungsgemäße Einprägen von Gitterdeformation und von kompressiver Spannung kann nun im Resultat der Zustand des im Schritt aa) bereitgestellten Templats alternativ dadurch definiert werden, dass es bei Wachstumstemperatur einen Wert $\varepsilon_{xx} < 0$, aufweist, wobei der Wert bevorzugt im Bereich von $0 > \varepsilon_{xx} > -0,0005$ liegt. Entsprechend liegt bei Raumtemperatur eine kompressive Spannung von $\sigma_{xx} < -0,70$ GPa vor, und die Deformation $\varepsilon_{xx}$ bei Raumtemperatur des Templats weist demnach einen Wert von $\varepsilon_{xx} < 0$, bevorzugt im Bereich $0 > \varepsilon_{xx} \geq -0,003$, weiter bevorzugt im Bereich $< - 0,002$, insbesondere im Bereich von -0,002 bis -0,004 und noch besser im Bereich $-0,0020 \geq \varepsilon_{xx} \geq -0,0025$.

Das epitaxiale Kristallwachstum von III-N-Kristall gemäß Schritt bb) dieser Ausführungsform kann entsprechend Schritt d) der oben beschriebenen Ausführungsform durchgeführt werden; auf die diesbezüglich entsprechende Beschreibung wird hier explizit Bezug genommen. In einer bevorzugten Ausführungsform wird dieses Wachstum mittels HVPE durchgeführt. Insbesondere ist das III-N-Material hier wiederum frei wählbar. Es ist aber bevorzugt, dass die III-N-Kristallschicht auf dem Substrat sowie die darauf epitaxial aufgewachsene III-N-Kristallschicht, die nun den III-N-Kristall bildet, aus demselben III-N-Material bestehen, oder dass die Veränderung der III-Komponente geringer als 10% beträgt. Ferner ist es möglich, dass bei der III-N-Kristallschicht auf dem Substrat sowie dem darauf epitaxial aufgewachsenen III-N-Kristall für die III-Komponente kein Materialaustausch vorgenommen wird. Wird kein Fremdsubstrat als Startsubstrat verwendet, sondern ein Homosubstrat, so ergibt sich als weitere mögliche Ausführungsform, das Startsubstrat, die III-N-Kristallschicht auf dem Startsubstrat sowie der darauf epitaxial aufgewachsene III-N-Kristall aus demselben III-N Material bestehen.

Erfindungsgemäß kann im Verfahren zur Herstellung von III-N-Einkristallen gemäß den oben beschriebenen Ausführungsformen ein epitaxiales Kristallwachstum auf dem bereitgestellten Templat durchgeführt werden, sodass nach Abschluss des epitaxialen Wachstums (Schritt e) bzw. Schritt bb) der beschriebenen Ausführungsformen) III-N-Einkristalle mit Schichtdicken von mindestens 1 mm, bevorzugt von mindestens 5 mm, mehr bevorzugt von mindestens 7 mm und am meisten bevorzugt von mindestens 1 cm erhalten werden.

Nach Beendigung des epitaxialen Kristallwachstums zur Herstellung eines III-N-Einkristalls kann optional der III-N-Einkristall vom Substrat getrennt werden (optionaler Schritt f) bzw. cc)). Dies geschieht in einer bevorzugten Ausführungsform durch Selbstablösung, etwa beim Abkühlen von einer Kristallwachstumstemperatur. In einer weiteren Ausführungsform kann das Trennen von III-N-Einkristall und dem Substrat durch Abschleifen, Absägen oder einen lift-off-Prozess geschehen.

Weist der epitaxial gewachsene III-N-Einkristall eine geeignete Dicke auf, wobei ein sogenannter III-N-Boule oder-Ingot erhalten wird, ist es möglich diesen Einkristall durch geeignete Methoden zum Bilden einer Vielzahl von einzelnen dünnen Scheiben (Wafer) zu vereinzeln. Das Vereinzeln der Einkristalle umfasst gängige Methoden zum Zerschneiden oder Zersägen von III-N-Einkristallen. Die so erhaltenen Wafer eignen sich hervorragend als Basis zur Herstellung von Halbleitervorrichtungen und Bauelementen, beispielsweise opto-elektronischen oder elektronischen Bauelementen. So eignen sich die erfindungsgemäß hergestellten Wafer zur Verwendung als Leistungsbauelemente, Hochfrequenzbauelemente, lichtemittierende Dioden und in Lasern.

Ein weiterer Gegenstand der vorliegenden Erfindung besteht in der Bereitstellung von Templaten bzw. an Fremdsubstrat anhaftenden III-N-Einkristallen. Diese Produkte sind über die oben beschriebenen Verfahren erhältlich und sind insbesondere als Grundmaterial zur Herstellung dickerer III-N-Schichten bzw. Boules (Massivkristalle) und als Basis zur Bauelementfertigung geeignet. Diese erfindungsgemäß bereitgestellten Produkte weisen in Bezug auf die III-N-Einkristalle die oben beschriebenen Parameter auf, u.a. die angegebenen Werte $\varepsilon_{xx} < 0$, bevorzugt im Bereich von $0 > \varepsilon_{xx} > -0{,}0005$ im Temperaturbereich eines epitaxialen Kristallwachstums, optional bei Raumtemperatur.

In allen Verfahrensstufen, insbesondere bei den eigentlichen, epitaxial gewachsenen III-N-Schichten und entsprechend im erfindungsgemäßen III-N-Einkristall sind der Einschluss von Dotierungen möglich. Geeignete Dotierungen umfassen n- sowie p-Dotierungen und können Elemente umfassen, die ausgesucht sind aus der Gruppe bestehend aus Be, Mg, Si, Ge, Sn, Pb, Se und Te.

Für semi-isolierendes Material können geeignete Dotierungen Elemente umfassen, die ausgesucht sind aus der Gruppe bestehend aus C, Fe, Mn und Cr.

In einer weiteren bevorzugten Ausführungsform ist der erhaltene III-N-Einkristall aus Galliumnitrid zusammengesetzt, und dieser Kristall weist in Wachstumsrichtung eine Gitterkonstante $a$ im Bereich von $< a_0$, insbesondere im Bereich von $0{,}31829 \text{ nm} < a \leq 0{,}318926 \text{ nm}$ auf. Als Referenzwert der Gitterkonstante $a_0$ von GaN kann hier der Wert $a_0 = 0{,}318926 \text{ nm}$ angenommen werden (vgl. V. Darakchieva, B. Monemar, A. Usui, M. Saenger, M. Schubert, Journal of Crystal Growth 310 (2008) 959-965)). Dies entspricht in etwa einer Gitterkonstante c im Bereich von $0 \leq \varepsilon_{zz} < +0{,}001$.

**Beispiele**

**Beispiel 1:**

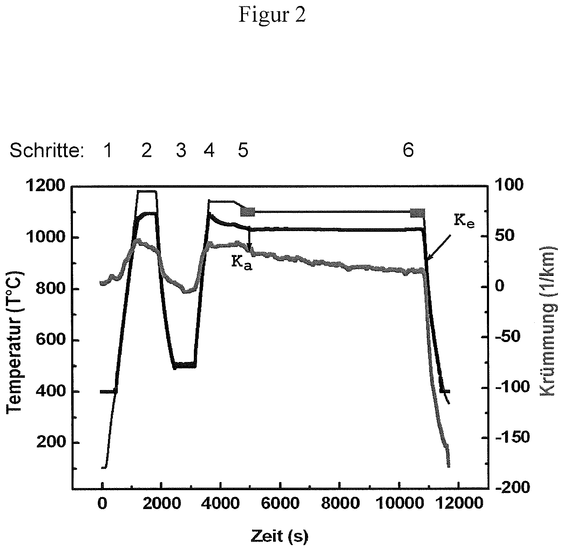

Das Beispiel 1 bezieht sich auf GaN-Wachstum, das auf einem Saphir-Startsubstrat durchgeführt wurde. Die einzelnen Schritte des Verfahrens sind veranschaulichend in Figuren 2 und 3 dargestellt. Fig. 2 zeigt die Veränderung der Krümmung der Wachstumsoberfläche (rechte Ordinate; untere Linie) je nach Verfahrensstufe 1 bis 6 (entsprechend den Stufen (i) bis (vi) der Figur 1) und jeweils angewandter Temperatur (linke Ordinate; obere und mittlere Linie). In Fig. 3 sind folgende Parameter im zeitlichen Verlauf aufgetragen: die Veränderung der Reflexion bei 950 nm (Diagramm oben, links) sowie der Temperatur (Diagramm oben, rechts, wobei die obere Kurve die eingestellte bzw. gesteuerte Prozesstemperatur und die untere Kurve die wirkliche Temperatur am Waferort wiedergeben) und die Veränderung der Krümmung der Wachstumsoberfläche (Diagramm unten). Die einzelnen Verfahrensschritte sind zwischen den zwei Teildiagrammen von Figur 3 angegeben, wobei der mit dem Ausdruck "GaN-Schicht" bezeichnete Verfahrensschritt aus Figur 3 nachfolgend als "Kristallwachstum" bezeichnet ist.

Die in Figur 3 angegeben Verfahrensschritte haben folgende Entsprechungen der Figur 1:

"Desorption" entspricht Stufe (ii) von Figur 1;
"GaN-Nukleation" entspricht Stufe (iii) von Figur 1;
"Rekristallisation" entspricht Stufe (iv) von Figur 1;
"T-Rampe" entspricht Stufe (v) von Figur 1;
"GaN-Schicht" entspricht Stufe (vi) von Figur 1;

Die Messung der Krümmung der Wachstumsoberfläche erfolgt in-situ. Die in-situ-Messungen wurden durchgeführt einer EpicurveTT-Krümmungsmessanlage der Firma LayTec (Berlin, Deutschland), die es erlaubt gleichzeitig Daten zur Temperatur, Reflexion und Krümmung der Wachstumsoberfläche zu erhalten.

Nachfolgend werden die Details eines ersten Ausführungsbeispiels zur Herstellung eines erfindungsgemäßen Templats beschrieben. Als Wachstumstechnik wird eine MOVPE verwendet. Die hier genannten Temperaturen beziehen sich auf die Temperatur der Heizer; die Temperatur am Templat bzw. Kristall liegt um ca. 200 K tiefer [vgl. Fig. 2: hier ist mit der oberen Linie die nominelle Heizertemperatur und mit der mittleren Linie die gemessene Temperatur der Waferaufnahme dargestellt.

Fremdsubstrat:

c-plane Saphirsubstrat
430 $\mu$m Dicke
unstrukturiert

Desorptionsschritt in MOVPE-Multiwaferreaktor

Reaktor: Aix2600 G3 oder G4
Reaktordruck: 200 hPa

Aufheizen: Von 400 °C auf 1180 °C in 13 min
Reaktortemperatur: 1180°C
Prozesstemperaturdauer: 10 min in $H_2$-Atmosphäre
Abkühlung auf 540°C

Nukleationsschritt

Gasströme: 20 sccm TMGa, 1slm $NH_3$
Abkühlung auf 530°C
Reduktion der Satellitenrotation durch Verringerung des Flusses auf je 100 sccm Öffnen der Ventile
Nukleation: 8 min 30 s
Erhöhung des Ammoniakflusses auf 5.5 slm

Rekristallisation

Aufheizen von 530 °C auf 1240°C in 8 min
Gleichzeitiges Rampen des Reaktordruck auf 600 hPa
Ceilingtemperatur: 370°C und
Gasstrom: 100 sccm TMGa, 16 slm $NH_3$. Danach Einstellen der Bedingungen für Koaleszenz:
Reaktordruck: Reduzierung von 600 hPa auf 500 hPa in 10 min
Gasstrom zur Erhöhung der Abscheiderate: 200 sccm TMG
Ceiling-Temperatur: 310 °C.

T-Rampe und Kristallwachstum:

Abkühlung von 1240 °C auf 1210 °C in 10 min
Reaktordruck: 500 hPa, $H_2$-Atmosphäre
Gasströme: 200 sccm TMGa, 5500 sccm $NH_3$
Kristallwachstumszeit: 90 min

Wachstumsende und Abkühlung:

Abschalten von Heizung und TMGa-Strom
Reduzierung $NH_3$: 5500 sccm auf 4 slm in 5 min
Abschalten: $NH_3$-Strom unter 700 °C
Umschalten: $NH_3$-Strom auf $N_2$-Strom
Wie aus Fig. 2 und 3 ersichtlich wird durch Anwenden der Temperaturrampe, d.h. dem Verringern von der "ersten" auf die "zweite" Wachstumstemperatur, die (hier konkave) Krümmung des Substrats (der darauf gebildet anfängliches GaN-Material aufweist) verringert auf einen Krümmungswert $K_a$, und diese (hier konkave) Krümmung $K_a$ wird im weiteren Verlauf des GaN-Kristallwachstums bei der "zweiten" Wachstumstemperatur weiter verringert, bis auf einen Krümmungswert $K_e$ am Ende des GaN-Kristallwachstums. Es gilt die Beziehung: Krümmung des Saphir $K_a$ (Pos. 5 in Fig. 2; auch gezeigt mit Pfeil und Punkt) > Krümmung des GaN/Saphir $K_e$ (Pos. 6 in Fig. 2; auch gezeigt mit Pfeil und Punkt), d.h. die GaN-Schicht ist intrinsisch kompressiv verspannt. Die Differenz $K_a$-$K_e$ beträgt hier $\geq$ 5 km$^{-1}$, sie kann aber durch Einstellen entsprechend größerer Temperaturunterschiede noch größer eingestellt werden, z.B. $\geq$ 10, $\geq$ 15, oder $\geq$ 20 km$^{-1}$.
Krümmung $K_A$ 36 km$^{-1}$
Krümmung $K_e$: 16 km$^{-1}$
Werte des erhaltenen GaN-Kristalls (nach Abkühlung):

3,5 $\mu$m dicke GaN-Schicht (nach 90 min MOVPE)
Gitterkonstante a: 0.31828
$\varepsilon_{xx}$-Wert: - 0,00203
$\sigma_{xx}$-Wert: -0,73 GPa

Halbwertsbreite der Rockingkurve: 200 arcsec am 002 Reflex und 380 arcsec am 302 Reflex bei einem Eingangsschlitz von 0,2 mm x 2 mm eines Philips X'Pert Pro.
Am Ende des GaN-Kristallwachstums bei der "zweiten" Wachstumstemperatur weist das GaN/Saphir-Templat folglich einen Krümmungswert K bei Kristallwachstumstemperatur von nur maximal 30 km$^{-1}$ auf. Somit wird ein Zustand des Templats bereitgestellt, wonach dieses im Temperaturbereich eines epitaxialen Kristallwachstums keine oder annähernd keine Krümmung aufweist.

Das weitere Prozedere kann je nach Wunsch gewählt werden. Zum Beispiel kann sich direkt ein zusätzliches epitaxiales Kristallwachstum zum Bilden von dickerem III-N-Kristall anschließen. Ein solches fortgesetztes Wachstum kann bei einer Kristallwachstumstemperatur durchgeführt werden, die im Prinzip unabhängig von den genannten ersten und zweiten Kristallwachstumstemperaturen gewählt werden kann.

Alternativ kann das Templat auf Raumtemperatur abgekühlt werden und zu einem späteren Zeitpunkt, gegebenenfalls an einem anderen Ort oder in einen anderen Reaktor plaziert werden, um später nach Wunsch weiterverwendet bzw. weiterverarbeitet zu werden. Wie aus Fig. 2 und 3 ersichtlich kippt die Krümmung im vorliegenden Beispiel im Verlauf der Abkühlung auf Raumtemperatur von konkav zu konvex. Durch eine Abkühlung wird der oben beschriebenen, intrinsisch kompressiven Verspannung der GaN-Schicht eine zusätzliche extrinsisch kompressive Verspannung hinzugefügt. Somit ist im Vergleich zu dem unten beschriebenen Vergleichsbeispiel die erfindungsgemäß erhaltene, kompressiv verspannte III-N-Schicht bei Raumtemperatur stärker kompressiv verspannt als eine nur durch extrinsische Kompression verspannte III-N-Schicht.

Wie sich überraschend gezeigt hat wirkt sich diese erfindungsgemäß erhaltene, kompressiv verspannte III-N-Schicht günstig auf das Krümmungsverhalten bei Raumtemperatur und vor allem bei dem ggf. wieder erhitzten Zustand aus. Wird nämlich das so erhaltene Templat wieder auf Betriebstemperatur, d.h. eine geeignete Epitaxie-Wachstumstemperatur erhitzt, wird der Zustand einer geringen oder fehlenden Krümmung ($K_e$) wiedererlangt, so dass der günstige Zustand für weiteres epitaxiales III-N-Kristallwachstum wieder erreicht ist.

**Beispiel 2:**

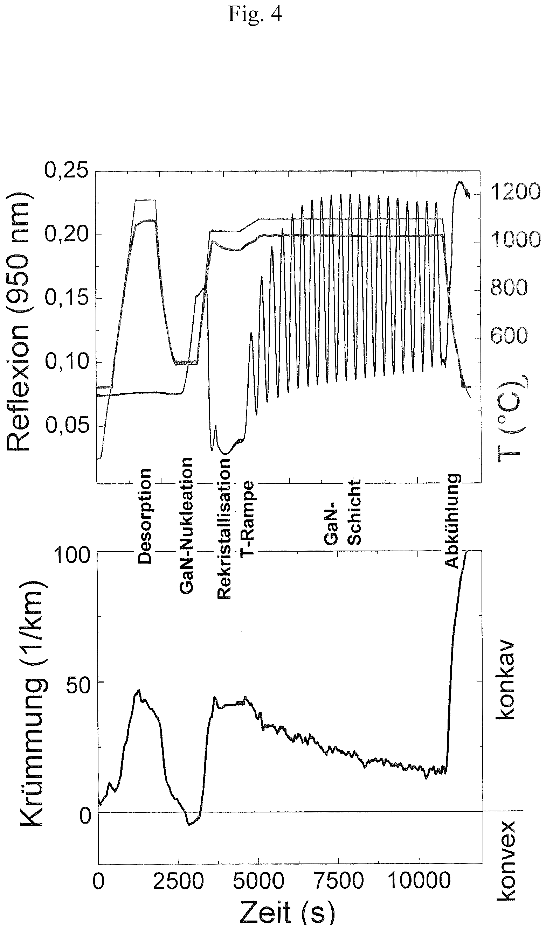

Dieses Beispiel bezieht sich auf GaN-Wachstum auf einem Fremdsubstrat, welches nicht wie in Beispiel 1 einen höheren (Saphir), sondern nun einen geringeren thermischen Ausdehnungskoeffizienten als GaN aufweist, beispielsweise Si oder SiC. Die Durchführung kann hier dem Beispiel 1 entsprechend erfolgen, jedoch mit dem Unterschied, dass die bezeichnete relevante Temperaturveränderung ("T-Rampe") nicht nach unten, sondern nach oben geht, wie schematisch durch eine entsprechende Figur 4 veranschaulicht. Der beabsichtigte Effekt ist jedoch qulitativ gleich, nämlich eine Abnahme der Krümmung $K_a - K_e > 0$ im Verlauf des weiteren III-N-Wachstums des Templats.

Sobald das Wachstum des Templats fertiggestellt ist, kann anschließende entweder direkt oder indirekt (ohne oder mit Unterbrechung) weiteres Wachstum auf diesem Templat folgen. Wahlweise wird das Templat auf Raumtemperatur abgekühlt, und in diesem Fall krümmt/verspannt sich das Templat bei einem solchen Abkühlen auf Raumtemperatur von Natur zusätzlich thermisch (extrinsisch), nunmehr weiter in die konkave Richtung wie in Fig. 4 gezeigt. Für die Weiterverwendung bzw. -verarbeitung gemäß der Erfindung wichtig ist jedoch, dass die zusätzliche thermische, extrinsische Verspannung/Krümmung reversibel ist und daher, wenn das erfindungsgemäß gebildete Templat wieder auf Betriebstemperatur für Epitaxiewachstum erhitzt wird, der Zustand einer geringen oder fehlenden Krümmung ($K_e$) wiedererlangt wird (vgl. Fig. 4, Zustand der Krümmung vor "Abkühlung"), so dass der günstige Zustand für weiteres epitaxiales III-N-Kristallwachstum wieder erreicht ist.

**Vergleichsbeispiel:**

In einem Vergleichsbeispiel können die gleichen Versuchsbedingungen verwendet werden außer, dass die Temperatur hier nicht abgesenkt wird.

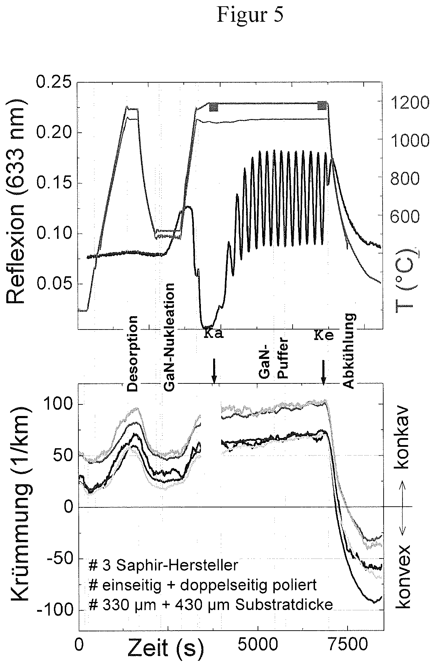

Fig. 5 zeigt typische in-situ Daten des MOVPE- Wachstum von GaN auf Saphir in einem solchen Vergleichsbeispiel, d.h. ohne Anwendung einer gezielten Temperaturrampe. Analog zu Fig. 3 und 4 sind folgende Parameter im zeitlichen Verlauf aufgetragen: die Veränderung der Reflexion bei 950 nm (Diagramm Ordinate oben, links) sowie der Temperatur (Diagramm Ordinate oben, rechts, wobei die obere Kurve die eingestellte bzw. gesteuerte Prozesstemperatur und die untere Kurve die wirkliche Temperatur am Waferort wiedergeben) und die Veränderung der Krümmung der Wachstumsoberfläche (Diagramm unten).

Das untere Bild zeigt die Entwicklung der Verkrümmung während des Prozesses für fünf verschiedene Saphirsubstrate. Die Pfeile verweisen auf die abzulesenden Krümmungswerte $K_a$ und $K_e$ (vgl. auch die durch quadratische Punkte gekennzeichneten Stellen der Termperaturkurve), und es gilt $K_a - K_e < 0$, d.h. GaN-Schicht ist intrinsisch tensil verspannt. Durch eine Abkühlung wird dieser Verspannung der GaN-Schicht eine extrinsisch kompressive Verspannung überlagert. Typische Werte für das Vergleichsbeispiel:

Krümmung $K_a$: 50 km$^{-1}$,
Krümmung $K_e$: 70 km$^{-1}$,
$\varepsilon_{xx}$-Wert: -0,0015,
$\sigma_{xx}$-Wert: -0,55 GPa.

**Beispiel 3:**

Auf dem gemäß Beispiel 1 hergestellten Templat und parallel dazu auf dem gemäß Vergleichsbeispiel hergestellten Templat werden in einer HVPE-Anlage mit üblichen Verfahrensparametern jeweils ca. 1 mm dicke GaN-Boules gewachsen. Im Vergleich zum Vergleichsbeispiel wirkt sich dabei die im Templat gemäß Beispiel 1 eingestellte geringfügige kompressive Verspannung vorteilhaft aus, indem die Neigung zur Rissbildung geringer ist.

**Beispiel 4**

In den nachfolgenden Beispielen 4 und 5 werden weitere Ausführungsbeispiele beschrieben, mit denen alternativ ein Templat bereitstellen, das im Temperaturbereich eines epitaxialen Kristallwachstums nicht oder im wesentlichen nicht gekrümmt ist oder negativ gekrümmt ist, welches Templat sich dann sehr gut zur Durchführen eines weiteren epitaxialen Kristallwachstums von III-N-Kristall eignet.
Als Wachstumstechnik wird hier z.B. eine MOVPE auf vorbehandeltem Saphir (der einer Desorption und einer Nukleation unterworfen wird) mit den nachfolgend wiedergegebenen Details verwendet. Die hier genannten Temperaturen beziehen sich auf die nominell eingestellte Temperatur der Heizer; die Temperatur am Templat bzw. Kristall liegt tiefer, teilweise bis um ca. 70 K tiefer.

Reaktor:

MOVPE-Reaktor Aixtron 200/4 RF-S, Einzel-Wafer, horizontal

Fremdsubstrat:

c-plane Saphirsubstrat, off-cut 0,2° in m-Richtung
430 $\mu$m Dicke
unstrukturiert

Desorptionsschritt (Fig. 6 (1); 100)

Reaktordruck: 100 mbar
Aufheizen: Von 400 °C auf 1200 °C in 7 min
Reaktortemperatur: 1200°C
Prozesstemperaturdauer: 10 min in $H_2$-Atmosphäre
Abkühlung auf 960°C

Nukleationsschritt (Fig. 6 (2); 101)

Gasströme: 25 sccm Trimethylaluminium (TMAl), Bubbler: 5° C, 250 sccm $NH_3$
Abkühlung auf 960°C
Öffnen der Ventile
Nukleation: 10 min
Erhöhung des Ammoniakflusses auf 1.6 slm

T-Rampe; ggf. Kristallwachstum (Fig. 6 (2) bis vor (3): 103)

Aufheizen von 960 °C auf 1100 °C in 40 sec
Reaktordruck: 150 mbar, $H_2$-Atmosphäre
Gasströme: ggf. 16-26 sccm Trimethylgallium (TMGa), 2475 sccm $NH_3$
Kristallwachstumszeit: 0 - 10 min (entsprechend 0-300 nm)

SiN-Abscheidung (Fig. 6 (3); 102)

Gasströme:: 0,113$\mu$mol/min Silan, 1475sccm NH3
Kein TMGa
Druck: 150 mbar
Temp: 1100°C
Dauer: 3 min

weiteres Kristallwachstum: (Fig. 6 (4); 104)

1100 °C
Reaktordruck: 150 mbar, $H_2$-Atmosphäre
Gasströme: 26 sccm TMGa, 2000 sccm $NH_3$
Kristallwachstumszeit 90-240 min, entsprechend 3-10 $\mu$m GaN-Dicke

Wachstumsende und Abkühlung: (Fig. 6 (5)-(6))

Abschalten von Heizung und TMGa-Strom
Reduzierung $NH_3$: 2000 sccm auf 500 sccm in 40 sec
Abschalten: $NH_3$-Strom unter 700 °C
Umschalten: $NH_3$-Strom auf $N_2$-Strom

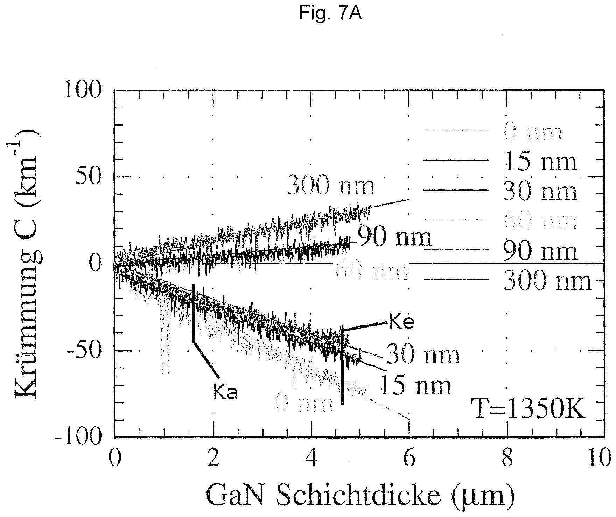

Fig. 7A zeigt den Verlauf der Krümmung bei Wachstumstemperatur (1350°K), aufgetragen gegen die Dicke der gewachsenen GaN-Schicht und damit im zeitlichen Verlauf, unterschieden je nach Abstand der SiN ($Si_xN_y$) gegenüber der AlN-Nukleationsschicht. Der Nullpunkt bezieht sich hierbei auf den Beginn des fortgesetzten Wachstum der III-N-Schicht 104A,104B (d.h. nach Stufe (3) und vor bzw. bei Stufe (4) in Fig. 6A/6B) Das Krümmungsverhalten kann gezielt und präzise gesteuert werden. Die nachfolgende Tabelle 1 gibt die in situ, also bei Wachstumstemperatur gemessenen $\varepsilon_{xx}$-Werte und die bei Raumtemperatur gemessenen Krümmungswerte C ($km^{-1}$) und die über C ermittelten $\varepsilon_{xx}$-Werte bei Raumtemeratur gegen Ende der Templatfertigung mit jeweiligen Dicken um ca. 7$\mu$m wieder.

Tabelle 1

| Distanz AlN und SiN | Dicke ($\mu$m) | $\varepsilon$ in-situ | C @ RT ($km^{-1}$) | $\varepsilon$ @ RT |
|---|---|---|---|---|
| 0 nm | 7,21 | -6,00E-04 | -396 | -2,27E-03 |
| 15 nm | 7,09 | -4,50E-04 | -365 | -2,13E-03 |
| 30 nm | 6,76 | -4,00E-04 | -367 | -2,24E-03 |
| 60 nm | 6,73 | 1,10E-04 | -298 | -1,83E-03 |
| 90 nm | 6,81 | 1,00E-04 | -299 | -1,82E-03 |
| 300 nm | 7,29 | 2,50E-04 | -293 | -1,66E-03 |

**Beispiel 5 und Vergleichsbeispiele**

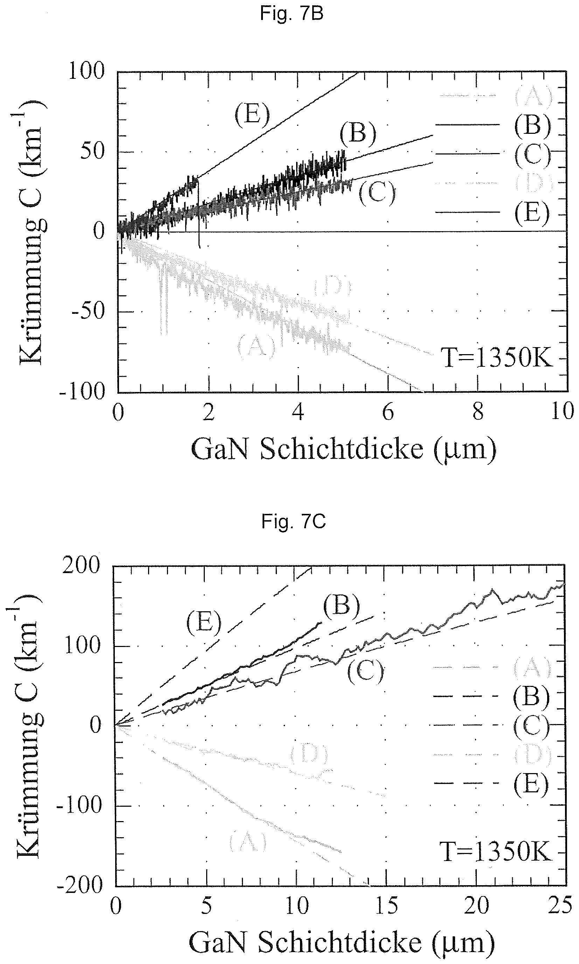

Auf ausgewählten, gemäß Beispiel 4 hergestellten Templaten, bei denen GaN-Schichten mit SiN-Zwischenschichten direkt auf der Nukleationsschicht (Probe A) oder nach sehr geringen (15-30nm; Probe D) oder größeren (300nm; Probe C) Abständen abgeschieden wurden oder gemäß Vergleichsbeispielen bei denen GaN ohne SiN (Probe B) oder aufNiedrigtemperatur-GaN-Nukleationsschicht (Probe E) gewachsen waren, wurde analog zu Beispiel 4 die Krümmung verfolgt, und zwar im Bereich eines MOVPE-Wachstums bis ca. 7$\mu$m wie in Fig. 7B gezeigt, oder bei Durchführung von weiterem HVPE-Wachstum bis ca. 25$\mu$m wie in Fig. 7C gezeigt. Die Ergebnisse der Figuren 7B und 7C zeigen nochmals das deutlich bessere Ergebnis hinsichtlich Einstellung und Verhalten der Krümmung der erfindungsgemäßen Template (A), (C) und (D) im Vergleich zu den Vergleichstemplaten (B) und (E) ohne SiN-Zwischenschicht.

**Patentansprüche**

**1.**   Verfahren zur Herstellung eines Templats, welches ein Substrat und mindestens eine III-N-Kristallschicht umfasst, wobei III mindestens ein Element der dritten Hauptgruppe des Periodensystems, ausgewählt aus Al, Ga und In, bedeutet, wobei das Verfahren die folgenden Schritte umfasst:

a) Bereitstellen eines Substrats, optional gefolgt von einem Nukleationsschritt,
b) Temperaturerhöhung auf eine erste Kristallwachstumstemperatur, die Kristallwachstum zum Bilden einer III-N-Schicht ermöglicht, und Durchführen von Wachstum eines kristallinen III-N-Materials auf dem in Schritt a) bereitgestellten Substrat bei der ersten Kristallwachstumstemperatur,
c) Verändern der Temperatur auf eine zweite Temperatur, die gegenüber der ersten Kristallwachstumstemperatur verändert ist, bei der jedoch weiterhin Kristallwachstum erfolgt,
d) Fortsetzen von Kristallwachstum zum Bilden von III-N-Kristall in einem gegenüber der ersten Wachstumstemperatur veränderten Bereich, ohne in diesem Schritt d) Indium zuzugeben

mit der Maßgabe, dass die zweite Temperatur im Schritt c) niedriger ist als die erste Temperatur und im Schritt d) das Kristallwachstum unterhalb der ersten Wachstumstemperatur fortgesetzt wird, wenn das verwendete Substrat einen höheren thermischen Ausdehnungskoeffizienten aufweist als der bis Schritt d) zu wachsende III-N-Kristall, oder dass die zweite Temperatur im Schritt c) höher ist als die erste Temperatur und im Schritt d) das Kristallwachstum oberhalb der ersten Wachstumstemperatur fortgesetzt wird, wenn das verwendete Substrat einen niedrigeren thermischen Ausdehnungskoeffizienten aufweist als der bis Schritt d) zu wachsende III-N-Kristall, wobei in Schritt c) die Temperatur bei Beginn oder während der Kristallitkoaleszenz verändert wird, und wobei im Anschluss an die besagte Temperaturveränderung ein Kristallwachstum auf den koaleszierten III-N-Kristalliten folgt, je nachdem wie festgelegt im Bereich unterhalb oder oberhalb der ersten Wachstumstemperatur, und wobei das in Schritt a) verwendete Substrat ein Fremdsubstrat mit höheren thermischen Ausdehnungskoeffizienten als der zu wachsende III-N-Kristall, ausgewählt aus der $LiAlO_2$ und Saphir umfassenden Gruppe, oder ein Fremdsubstrat mit niedrigerem thermischen Ausdehnungskoeffizienten als der zu wachsende III-N-Kristall, ausgewählt aus der SiC und Si umfassenden Gruppe, ist.

2. Verfahren gemäß Anspruch 1 zur Herstellung eines III-N- Einkristalls, zusätzlich folgende Schritte aufweisend:

   e) zusätzliches epitaxiales Kristallwachstum zum Bilden von III-N-Kristall bei einer Kristallwachstumstemperatur, die unabhängig von den genannten ersten und zweiten Temperaturen gewählt werden kann, wobei gegebenenfalls in diesem Schritt e) Indium zugegeben werden kann, und
   f) optional Trennen von gebildeten III-N-Einkristall und Substrat,

   wobei der Schritt e) vorzugsweise in einem anderen Reaktor durchgeführt wird und vorzugsweise unter HVPE-Bedingungen durchgeführt wird.

3. Verfahren gemäß Anspruch 1 oder 2, **dadurch gekennzeichnet, dass** in Schritt c) die Veränderung, d.h. Absenkung oder Erhöhung der Temperatur eine Temperaturdifferenz $\Delta T$ ($T_1$-$T_2$) im Reaktor festlegt, deren Betrag bei mindestens 10°C, vorzugsweise im Bereich von 10-100 °C, weiter bevorzugt im Bereich von 20-50°C liegt.

4. Verfahren gemäß einem der vorangehenden Ansprüche, **dadurch gekennzeichnet, dass** während einer Wachstumsphase im Schritt d) bei Wachstumstemperatur eine gegebene Krümmung der Wachstumsoberfläche, kontinuierlich oder intermittierend, abnimmt, und/oder dass die Krümmungsdifferenz ($K_a$-$K_e$) des Templats zu Beginn ($K_a$) und am Ende ($K_e$) von Schritt d) bei Wachstumstemperatur ein positives Vorzeichen aufweist, bevorzugt mindestens 5 km$^{-1}$, weiter bevorzugt mindestens 10 km$^{-1}$ beträgt, und/oder dass mit dem Schritt d) zum Bilden eines Templats eine III-N-Schicht mit einer Dicke im Bereich von 0,1-10 $\mu$m auf das Substrat aufgetragen worden ist.

5. Verfahren zur Herstellung von III-N-Einkristall, wobei III mindestens ein Element der dritten Hauptgruppe des Periodensystems, ausgewählt aus Al, Ga und In, bedeutet, wobei das Verfahren die folgenden Schritte umfasst:

   aa) Ausführen des Verfahrens gemäß einem der vorangehenden Ansprüche zum Bereitstellen eines Templats, welches ein Fremdsubstrat und mindestens eine III-N-Kristallschicht umfasst, wobei das Templat im Temperaturbereich eines epitaxialen Kristallwachstums nicht oder im wesentlichen nicht gekrümmt ist oder negativ, also konvex, gekrümmt ist,
   bb) Durchführen eines epitaxialen Kristallwachstums von III-N-Kristall bei einer Kristallwachstumstemperatur auf dem Templat, bei der das Templat nicht oder im wesentlichen nicht gekrümmt ist oder negativ gekrümmt ist, wobei in den Schritten aa) und bb) bevorzugt kein In zugegeben wird, und
   cc) optional zusätzliches epitaxiales Kristallwachstum zum Bilden von III-N-Kristall bei einer Kristallwachstumstemperatur, die unabhängig von der genannten Kristallwachstumstemperaturen des Schritts bb) gewählt werden kann, wobei gegebenenfalls in diesem Schritt cc) In zugegeben werden kann, und
   dd) weiter optional Trennen von III-N-Einkristall und Fremdsubstrat.

6. Verfahren gemäß Anspruch 5, **dadurch gekennzeichnet, dass** nach Abschluss von Schritt bb) die Bedingung von "im wesentlichen nicht gekrümmt" oder "negativ gekrümmt" bedeutet, dass bei Kristallwachstumstemperatur die Krümmung ($K_e$) im Bereich von maximal 30 km$^{-1}$ liegt, die Krümmung konvex ist und/oder dass in Schritt aa) die mindestens eine III-N-Kristallschicht kein Indium enthält, und/oder dass in Schritt bb) beim epitaxialen Kristallwachstum von III-N-Kristall kein Indium zugegeben wird, und/oder dass das im Schritt aa) bereitgestellte Templat durch ein Verfahren gemäß einem der Ansprüche 1 bis 4 hergestellt wurde.

7. Verfahren gemäß Anspruch 5 oder 6, **dadurch gekennzeichnet, dass** das im Schritt aa) bereitgestellte Templat dadurch hergestellt wurde, dass während des Wachstums, oder in einer intermittierenden Zwischenstufe zu Beginn oder zwischen Beginn und Fortsetzung des Wachstums, eines kristallinen III-N-Materials für die besagte III-N-Kristallschicht auf dem Substrat ein Maskenmaterial als Zwischenschicht auf dem Substrat, welches gegebenenfalls eine III-N-Nukleationsschicht aufweist, oder im kristallinen III-N-Material selbst in einem maximalen Abstand vom Substrat oder der gegebenenfalls vorgesehenen III-N-Nukleationsschicht von 300nm, bevorzugt bei einem Abstand von unter 100nm, weiter bevorzugt bis maximal 50nm, abgeschieden wird und danach das Wachstum des kristallinen III-N-Materials für die besagte III-N-Kristallschicht erfolgt oder fortgesetzt wird, und/oder dass in Schritt aa) das III-N-Materials des Templats

(i) bei Raumtemperatur eine kompressive Spannung von $\sigma_{xx}$<-0,70 GPa aufweist; oder
(ii) einen Wert $\varepsilon_{xx}$ im Temperaturbereich eines epitaxialen Kristallwachstums von $\varepsilon_{xx}$<0 aufweist, und optional einen Wert $\varepsilon_{xx}$ bei Raumtemperatur von $\varepsilon_{xx}$ < 0 aufweist, wobei $\varepsilon_{xx}$ mit Hilfe einer Röntgenmessung der absoluten Gitterkonstante bestimmt wird .

8. Verfahren gemäß einem der vorangehenden Ansprüche, **dadurch gekennzeichnet, dass** das in Schritt a) bzw. aa) verwendete Substrat ein Fremdsubstrat ist mit höherem thermischen Ausdehungskoeffizienten als der zu wachsende III-N-Kristall, ausgewählt aus der LiAlO$_2$ und Saphir umfassenden Gruppe, bevorzugt Saphir ist, oder dass das in Schritt a) bzw. aa) verwendete Substrat ein Fremdsubstrat ist mit niedrigerem thermischen Ausdehungskoeffizienten als der zu wachsende III-N-Kristall, ausgewählt aus der SiC und Si umfassenden Gruppe.

9. Verfahren zur Herstellung von III-N-Einkristall gemäß einem der Ansprüche 5 bis 8, **dadurch gekennzeichnet, dass** in Schritt aa) das Templat, wenn als Substrat Saphir einer Dicke ($d_{Saphir}$) von 430$\mu$m und als III-N-Kristallschicht des Templats GaN einer Dicke ($d_{GaN}$) von 3,5 $\mu$m verwendet oder eingestellt wird, bei Raumtemperatur eine Krümmung $K_{T(3,5\mu m;430\mu m)}$<-170 km$^{-1}$, bevorzugt im Bereich von -170>$K_T$>-250 km$^{-1}$ aufweist, wobei die Krümmung konvex ist und wobei bei Verwendung oder Einstellung anderer Schichtdicken der Krümmungswert in Abhängigkeit der jeweiligen Schichtdicken analog der Stoney-Gleichung im folgenden Bereich liegt, sofern der Film ($d_{GaN}$) wesentlich dünner ist als das Substrat ($d_{Substrat}$) und $\varepsilon_{xx}$ als konstant angenommen wird:

$$K_{T(dGaN;dSaphir)}=K_{T(3,5\mu m;430\mu m)}x(430\mu m/d_{Saphir})^2 x(d_{GaN}/3,5\mu m).$$

10. Verfahren zur Herstellung von III-N-Einkristall gemäß einem der Ansprüche 2 bis 9, **dadurch gekennzeichnet, dass** nach Abschluss des epitaxialen Wachstums III-N-Einkristalle gewachsen werden mit Schichtdicken von mindestens 1 mm, bevorzugt von mindestens 5 mm, weiter bevorzugt von mindestens 7 mm und am meisten bevorzugt von mindestens 1 cm.

11. Verfahren zur Herstellung von III-N-Kristallwafern, wobei III mindestens ein Element der dritten Hauptgruppe des Periodensystems ausgesucht aus der Gruppe von Al, Ga und In bedeutet, wobei das Verfahren die folgenden Schritte umfasst:

a) Durchführung eines Verfahrens gemäß einem der Ansprüche 2 bis 10 zum Bilden eines III-N-Einkristalls, und
b) Vereinzeln des Einkristalls zum Bilden von Wafern.

12. III-N-Einkristall anhaftend an einem Fremdsubstrat, wobei III mindestens ein Element der dritten Hauptgruppe des Periodensystems, ausgewählt aus der Gruppe von Al, Ga und In, bedeutet, wobei eine III-N-Kristallschicht auf dem Substrat sowie eine darauf epitaxial aufgewachsene III-N-Kristallschicht, die den III-N-Kristall bildet, aus demselben III-N-Material bestehen, **dadurch gekennzeichnet, dass** der III-N-Einkristall folgenden Wert (i) der Deformation $\varepsilon_{XX}$ aufweist:

(i) im Temperaturbereich eines epitaxialen Kristallwachstums liegt der $\varepsilon_{XX}$-Wert < 0; und optional folgenden Wert der Deformation $\varepsilon_{XX}$ aufweist:
(ii) bei Raumtemperatur liegt der $\varepsilon_{XX}$-Wert < 0, wenn das III-N-Einkristall in Form eines Templats mit einer Schichtdicke des auf dem Substrat aufgetragenen III-N-Einkristalls im Bereich von 0,1-10 $\mu$m ausgebildet ist, oder der III-N-Einkristall die folgenden Werte der Deformation $\varepsilon_{XX}$ aufweist: $\varepsilon_{XX}$ < 0, bevorzugt in einem Bereich von 0 > $\varepsilon_{XX}$ > -0,0005, im Temperaturbereich eines epitaxialen Kristallwachstums sowie bei Raumtemperatur, wenn das III-N-Einkristall mit einer Schichtdicke von mindestens 1 mm ausgebildet ist,

wobei $\varepsilon_{xx}$ mit Hilfe einer Röntgenmessung der absoluten Gitterkonstante bestimmt wird, und
wobei das Fremdsubstrat aus der LiAlO$_2$, Saphir, SiC und Si umfassenden Gruppe ausgewählt ist.

**13.** III-N-Einkristall gemäß Anspruch 12 in Form eines Templats mit einer Schichtdicke des auf dem Substrat aufgetragenen III-N-Einkristalls von 2-5 $\mu$m.

**14.** III-N-Einkristall gemäß Anspruch 12 oder 13, **dadurch gekennzeichnet, dass** das Fremdsubstrat Saphir umfasst, bevorzugt aus Saphir besteht, und/oder dass der Kristall nach einem Verfahren gemäß einem der Ansprüche 1 bis 10 hergestellt wurde.

**15.** Verwendung eines III-N-Einkristalls gemäß einem der Ansprüche 12 bis 14 zur Herstellung von dickeren III-N-Schichten oder III-N-Kristallboules bzw. -Massivkristalle, die optional danach in einzelne III-N-Wafer vereinzelt werden, und/oder Verwendung von nach Anspruch 11 hergestellten III-N-Wafern, oder Verwendung eines III-N-Einkristalls gemäß einem der Ansprüche 12 bis 14, jeweils zur Herstellung von Halbleiterbauelementen, elektronischen oder optoelektronischen Bauelementen.

**Claims**

**1.** A process for producing a template comprising a substrate and at least one III-N crystal layer, wherein III denotes at least one element of the third main group of the periodic table of the elements, selected from Al, Ga and In, the process comprising the following steps:

> a) providing a substrate, optionally followed by a nucleation step,
> b) temperature increase to a first crystal growth temperature which enables crystal growth for forming a III-N-layer, and carrying out of growth of a crystalline III-N material on the substrate as provided in step a) at the first crystal growth temperature,
> c) changing the temperature to a second temperature which is changed compared with the first crystal growth temperature, at which however crystal growth occurs,
> d) continuing crystal growth for forming of III-N crystal within a temperature range changed compared with the first growth temperature, without adding indium in this step d),

with the proviso that the second temperature in step c) is lower than the first temperature and in step d) the crystal growth is continued below the first growth temperature, if the substrate used has a higher thermal expansion coefficient than the III-N crystal to be grown until step d),
or that the second temperature in step c) is higher than the first temperature and in step d) the crystal growth is continued above the first growth temperature, if the substrate used has a lower thermal expansion coefficient than the III-N crystal to be grown until step d),
wherein in step c), the temperature is changed at the beginning of crystallite coalescence, and wherein subsequent to said temperature change, a crystal growth follows on the coalesced III-N-crystallites, as the case may be set in the range above or below the first crystal growth temperature, and
wherein the substrate used in step a) is a foreign substrate having a higher thermal expansion coefficient than the III-N crystal to be grown, selected from the group consisting of LiAlO$_2$ and sapphire, or is a foreign substrate having a lower thermal expansion coefficient than the III-N crystal to be grown, selected from the group consisting of SiC and Si.

**2.** The process according to claim 1 for producing a III-N single crystal, additionally comprising the following steps:

> e) additional epitaxial crystal growth for forming of III-N crystal at a crystal growth temperature which can be selected independently from said first and second temperatures, wherein optionally, in this step e) indium may be added, and
> f) optionally separating of formed III-N single crystal and substrate,

wherein step e) is preferably carried out in another reactor and is preferably carried out under HVPE conditions.

**3.** The process according to claim 1 or 2, **characterized in that** in step c), the change, i.e. lowering or raising of the temperature, sets a temperature difference $\Delta T$ ($T_1$-$T_2$) within the reactor, which value is at least at 10°C, preferably lies within the range of 10-100°C, more preferably lies within the range of 20-50°C.

4. The process according to any one of the preceding claims, **characterized in that** during a growth phase in step d) at growth temperature a given curvature of the growth surface decreases continually or intermittently, and/or that the curvature difference $(K_a-K_e)$ of the template has a positive algebraic sign at the beginning (curvature value $K_a$) and at the end (curvature value $K_e$) of step d) at growth temperature, preferably at least 5 $km^{-1}$, more preferably at least 10 $km^{-1}$, and that by means of step d) for forming a template, a III-N layer having a thickness within the range of 0.1-10 $\mu m$ has been deposited onto the substrate.

5. A process for producing a III-N single crystal, wherein III denotes at least one element of the third main group of the periodic table of the elements, selected from Al, Ga and In, the process comprising the following steps:

aa) Carrying out a process according to one of the previous claims for providing a template comprising a foreign substrate and at least one III-N crystal layer, wherein within the temperature range of an epitaxial crystal growth, the template is not or essentially not curved or is negatively curved, i.e. in a convex manner.

bb) carrying out epitaxial crystal growth of a III-N crystal at a crystal growth temperature at which the template is not or essentially not curved or is negatively curved,
wherein it is preferred that in steps aa) and bb), no In is added, and

cc) optionally additional epitaxial crystal growth for forming of a III-N crystal at a crystal growth temperature which can be selected independently from said crystal growth temperatures mentioned in step bb), wherein optionally, in this step cc) In may be added, and

dd) furthermore, optionally separating III-N single crystal and foreign substrate.

6. The process according to claim 5, **characterized in that** after completion of step bb) the proviso of "essentially not curved" or "negatively curved" means that the curvature $(K_e)$ is within the range of at most 30 $km^{-1}$ at crystal growth temperature, the curvature is convex and/or in step aa) the at least one III-N crystal layer contains no indium, and/or that in step bb) during the epitaxial crystal growth of III-N crystal no indium is added, and/or the template as provided in step aa) is produced by a process according to one of claims 1 to 4.

7. The process according to any one of claims 5 or 6, **characterized in that** the template provided in step aa) is produced **in that** during the growth, or in an intermittent intermediate stage at the beginning or between the beginning and continuation of the growth, of a crystalline III-N material for said III-N crystal layer on the substrate a mask material is deposited as interlayer on the substrate, which optionally exhibits a III-N nucleation layer, or in the crystalline III-N material itself at a maximum distance from the substrate, or respectively from the optionally provided III-N nucleation layer, of 300 nm, preferably at a distance of below 100 nm, more preferably of up to a maximum of 50 nm, and subsequently the growth of the crystalline III-N material for said III-N crystal layer is carried out or continued, and/or that in step aa), the template

(i) has a compressive stress of $\sigma_{xx}<-0.70$ GPa at room temperature; or
(ii) has a value $\varepsilon_{XX}$ within the temperature range of an epitaxial crystal growth of $\varepsilon_{XX}<0$, and optionally a value $\varepsilon_{XX}$ at room temperature of $\varepsilon_{XX}<0$, wherein $\varepsilon_{XX}$ is determined by an X-ray measurement of the absolute lattice constant.

8. The process according to any one of the preceding claims, **characterized in that** the substrate used in step a) or respectively aa) is a foreign substrate having a higher thermal expansion coefficient than the III-N crystal to be grown, selected from the group consisting of $LiAlO_2$ and sapphire, preferably it is sapphire, or that the substrate used in step a) or respectively aa) is a foreign substrate having a lower thermal expansion coefficient than the III-N crystal to be grown, selected from the group consisting of SiC and Si.

9. The process for preparing a III-N single crystal according to any one of claims 5 to 8, **characterized in that** in step aa), when sapphire of a thickness $(d_{sapphire})$ of 430 $\mu m$ is used or set as substrate and GaN of a thickness $(d_{GaN})$ of 3.5 $\mu m$ is used or set as III-N crystal layer of the template, the template has a curvature $K_{T(3.5\mu m;430\mu m)}<-170$ $km^{-1}$ at room temperature, preferably within the range of -170 $km^{-1}>K_T>-250$ $km^{-1}$, wherein when using or setting other layer thicknesses, the curvature value lies depending on the respective layer thicknesses analogous to the Stoney equation in the following range, if the film $(d_{GaN})$ is substantially thinner than the substrate $(d_{Substrate})$, and $\varepsilon_{XX}$ is considered as constant:

$$K_{T(dGaN;dsapphire)}=K_{T(3.5\mu m;430\mu m)}\times(430\mu m/d_{sapphire})^2\times(d_{GaN}/3.5\mu m).$$

10. The process for preparing a III-N single crystal according to any one of claims 2 to 9, **characterized in that** after completion of the epitaxial growth, III-N single crystals are grown having layer thicknesses of at least 1 mm, preferably of at least 5 mm, more preferably of at least 7 mm and most preferably of at least 1 cm.

11. A process for producing III-N crystal wafers, wherein III denotes at least one element of the third main group of the periodic table of the elements, selected from Al, Ga and In, the process comprising the following steps:

a) carrying out a process according to claims 2 to 10 for forming a III-N single crystal, and
b) separating the single crystal for forming wafers.

12. A III-N single crystal adhering to a foreign substrate, wherein III denotes at least one element of the third main group of the periodic table of the elements, selected from the group of Al, Ga and In, wherein a III-N crystal layer on the substrate and a III-N crystal layer epitaxially grown thereon, which forms the III-N crystal, are of the same III-N material, **characterized in that** the III-N single crystal exhibits the following values (i)/(ii) of the deformation $\varepsilon_{XX}$:

(i) within the temperature range of an epitaxial crystal growth the $\varepsilon_{XX}$-value lies in the range of < 0; and optionally exhibits the following deformation value $\varepsilon_{XX}$:
(ii) at room temperature the $\varepsilon_{XX}$-value lies in the range of < 0, if the III-N single crystal is formed in the form of a template with a layer thickness of the III-N single crystal deposited onto the substrate of 0.1 - 10 $\mu$m.

or the III-N single crystal exhibits the following deformation values $\varepsilon_{XX}$:

$\varepsilon_{XX}$ < 0, preferably in the range of 0 > $\varepsilon_{XX}$ > -0.0005 in the temperature range of an epitaxial growth and at room temperature if the III-N single crystal is formed with a layer thickness of at least 1 mm,
wherein $\varepsilon_{XX}$ is determined with an X-ray measurement of the absolute lattice constant, and
wherein the foreign substrate is selected from the group consisting of $LiAlO_2$, sapphire, SiC and Si.

13. The III-N single crystal according to claim 12 in the form of a template having a layer thickness of the III-N single crystal deposited to the substrate of 2-5 $\mu$m.

14. The III-N single crystal according to claim 12 or 13, **characterized in that** the foreign substrate comprises sapphire, preferably consists of sapphire, and/or that the crystal was produced according to a process according to any one of claim 1 to 10.

15. Use of a III-N single crystal according to any one of claims 12 to 14 for producing thicker III-N layers or III-N crystal boules or respectively bulk crystals, which are thereafter optionally separated into individual III-N wafers, and/or use of III-N wafers produced according to claim 11 or use of a III-N single crystal according to any one of claims 12 to 14, respectively for producing semiconductor elements, electronic or optoelectronic devices.

**Revendications**

1. Procédé de fabrication d'un substrat composite, qui comprend un substrat et au moins une couche cristalline III-N, dans lequel III correspond à au moins un élément du troisième groupe principal du système périodique, choisi parmi Al, Ga et In, lequel procédé comprend les étapes suivantes :

a) préparation d'un substrat, suivie optionnellement d'une étape de nucléation,
b) augmentation de température jusqu'à une première température de croissance cristalline, qui permet une croissance cristalline en vue de former une couche III-N, et réalisation d'une croissance d'un matériau III-N cristallin sur le substrat préparé à l'étape a) à la première température de croissance cristalline,
c) modification de la température jusqu'à une deuxième température qui est modifiée par rapport à la première température de croissance cristalline mais à laquelle une croissance cristalline continue toutefois à s'effectuer,
d) poursuite de la croissance cristalline en vue de former du cristal III-N dans une plage de température modifiée par rapport à la première température de croissance, sans ajouter d'indium dans cette étape d),

dans la mesure où la deuxième température à l'étape c) est inférieure à la première température et où la croissance cristalline à l'étape d) se poursuit au-dessous de la première température de croissance lorsque le substrat utilisé présente un coefficient de dilatation thermique supérieur à celui du cristal III-N devant croître jusqu'à l'étape d), ou

dans la mesure où la deuxième température à l'étape c) est supérieure à la première température et où la croissance cristalline à l'étape d) se poursuit au-dessus de la première température de croissance lorsque le substrat utilisé présente un coefficient de dilatation thermique inférieur à celui du cristal III-N devant croître jusqu'à l'étape d),

dans lequel, à l'étape c), la température est modifiée au début ou pendant la coalescence de cristallites et dans lequel, à la suite de ladite modification de température, une croissance cristalline sur les cristallites III-N coalescés s'effectue, que ce soit comme on l'a spécifié dans la plage au-dessous ou au-dessus de la première température de croissance, et

dans lequel le substrat utilisé à l'étape a) est un substrat étranger avec un coefficient de dilatation thermique supérieur à celui du cristal III-N devant croître, choisi dans le groupe comprenant le LiAlO$_2$ et le saphir, ou un substrat étranger avec un coefficient de dilatation thermique inférieur à celui du cristal III-N devant croître, choisi dans le groupe comprenant SiC et Si.

2. Procédé selon la revendication 1 et destiné à la fabrication d'un monocristal III-N, comportant en plus les étapes suivantes :

e) croissance cristalline épitaxiale supplémentaire pour former du cristal III-N à une température de croissance cristalline qui peut être choisie indépendamment des première et deuxième températures mentionnées, de l'indium pouvant éventuellement être ajouté dans cette étape e), et
f) optionnellement, séparation du monocristal III-N formé et du substrat,

dans lequel l'étape e) est effectuée de préférence dans un autre réacteur et de préférence dans des conditions HVPE.

3. Procédé selon la revendication 1 ou 2, **caractérisé en ce que**, à l'étape c), la modification, c'est-à-dire la diminution ou l'augmentation, de la température donne dans le réacteur une différence de température $\Delta T$ ($T_1$-$T_2$) dont la valeur est au moins égale à 10 °C et est comprise de préférence entre 10 et 100 °C, encore de préférence entre 20 et 50 °C.

4. Procédé selon l'une quelconque des revendications précédentes, **caractérisé en ce que**, pendant une phase de croissance à l'étape d) à la température de croissance, une courbure donnée de la surface de croissance diminue, de manière continue ou intermittente, et/ou **en ce que** la différence de courbure ($K_a$-$K_e$) du substrat composite au début ($K_a$) et à la fin ($K_e$) de l'étape d) à la température de croissance a un signe positif et est égale de préférence à au moins 5 km$^{-1}$, encore de préférence à au moins 10 km$^{-1}$, et/ou **en ce que**, à l'étape d), en vue de former un substrat composite, une couche III-N d'une épaisseur comprise entre 0,1 et 10 $\mu$m a été appliquée sur le substrat.

5. Procédé de fabrication d'un monocristal III-N, dans lequel III correspond à au moins un élément du troisième groupe principal du système périodique, choisi parmi Al, Ga et In, et dans lequel le procédé comprend les étapes suivantes :

aa) exécution du procédé selon l'une quelconque des revendications précédentes afin de préparer un substrat composite qui comprend un substrat étranger et au moins une couche cristalline III-N, le substrat composite dans la plage de température d'une croissance cristalline épitaxiale n'étant pas courbé ou n'étant globalement pas courbé ou étant courbé de manière négative, c'est-à-dire convexe,
bb) réalisation d'une croissance cristalline épitaxiale de cristal III-N sur le substrat composite à une température de croissance cristalline à laquelle le substrat composite n'est pas courbé ou n'est globalement pas courbé ou est courbé de manière négative,
dans lequel de préférence aucun In n'est ajouté aux étapes aa) et bb) et
cc) optionnellement, croissance cristalline épitaxiale supplémentaire en vue de former un cristal III-N à une température de croissance cristalline qui peut être choisie indépendamment de la température de croissance cristalline mentionnée de l'étape bb), de l'indium In pouvant éventuellement être ajouté dans cette étape cc), et
dd) encore optionnellement, séparation du monocristal III-N et du substrat étranger.

6. Procédé selon la revendication 5, **caractérisé en ce que**, après la fin de l'étape bb), la condition « globalement pas courbé » ou « courbé de manière négative » signifie que, à la température de croissance cristalline, la courbure ($K_c$) est dans une plage allant au maximum jusqu'à 30 km$^{-1}$, la courbure est convexe et/ou **en ce que**, à l'étape aa), l'au moins une couche cristalline III-N ne contient pas d'indium et/ou **en ce que**, à l'étape bb), lors de la croissance cristalline épitaxiale du cristal III-N, aucun indium n'est ajouté et/ou **en ce que** le substrat composite préparé à l'étape aa) a été fabriqué par un procédé selon l'une des revendications 1 à 4.

7. Procédé selon la revendication 5 ou 6, **caractérisé en ce que** le substrat composite préparé à l'étape aa) a été fabriqué par le fait que, pendant la croissance, ou dans une étape intermédiaire intermittente au début ou entre le début et la suite de la croissance, d'un matériau III-N cristallin pour ladite couche cristalline III-N sur le substrat, un matériau de masquage est déposé comme couche intermédiaire sur le substrat, qui comporte éventuellement une couche de nucléation III-N, ou dans le matériau III-N cristallin lui-même à une distance maximale de 300 nm du substrat ou de la couche de nucléation III-N éventuellement prévue, de préférence à une distance de moins de 100 nm, encore de préférence à une distance de 50 nm au maximum, et la croissance du matériau III-N cristallin pour ladite couche cristalline III-N s'effectue ou se poursuit ensuite, et/ou **en ce que**, à l'étape aa), le matériau III-N du substrat composite

(i) présente à température ambiante une tension compressive de $\sigma_{xx}$ <-0,70 GP$_A$ ; ou

(ii) a une valeur $\varepsilon_{xx}$, dans la plage de température d'une croissance cristalline épitaxiale, de $\varepsilon_{xx}$ < 0, et option-nellement une valeur $\varepsilon_{xx}$ à température ambiante de $\varepsilon_{xx}$ < 0, $\varepsilon_{xx}$ étant déterminée à l'aide d'une mesure aux rayons X de la constante de réseau absolue.

8. Procédé selon l'une quelconque des revendications précédentes, **caractérisé en ce que** le substrat utilisé à l'étape a) ou aa) est un substrat étranger avec un coefficient de dilatation thermique supérieur à celui du cristal III-N devant croître, choisi dans le groupe comprenant le LiAlO$_2$ et le saphir, de préférence le saphir, ou **en ce que** le substrat utilisé à l'étape a) ou aa) est un substrat étranger avec un coefficient de dilatation thermique inférieur à celui du cristal III-N devant croître, choisi dans le groupe comprenant SiC et Si.

9. Procédé de fabrication d'un monocristal III-N selon l'une quelconque des revendications 5 à 8, **caractérisé en ce que**, à l'étape aa), lorsqu'on utilise ou met en place comme substrat un saphir d'une épaisseur ($d_{saphir}$) de 430 $\mu$m et comme couche cristalline III-N du substrat composite un GaN d'une épaisseur ($d_{GaN}$) de 3,5 $\mu$m, le substrat composite présente à température ambiante une courbure K$_{T(3,5\mu m;430\,\mu m)}$<-170km-1, de préférence dans la plage -170>K$_T$>-250km$^{-1}$, laquelle courbure est convexe et, lors de l'utilisation ou de la mise en place d'autres épaisseurs de couche, la valeur de courbure est dans la plage ci-dessous, en fonction des épaisseurs de couches respectives et de manière analogue à l'équation de Stoney, dans la mesure où le film ($d_{GaN}$) est nettement plus mince que le substrat ($d_{Substrat}$) et où $\varepsilon_{xx}$ est supposée constante :

$$K_{T(dGaN,dsaphir)} = K_{T(3,5\,\mu m;430\,\mu m)} \times (430\ \mu m/d_{saphir})^2 \times (d_{GaN}/3{,}5\ \mu m).$$

10. Procédé de fabrication d'un monocristal III-N selon l'une quelconque des revendications 2 à 9, **caractérisé en ce que**, après la fin de la croissance épitaxiale, on obtient des monocristaux III-N avec des épaisseurs de couches d'au moins 1 mm, de préférence d'au moins 5 mm, encore de préférence d'au moins 7 mm et encore plus de préférence d'au moins 1 cm.

11. Procédé de fabrication de tranches cristallines III-N, dans lequel III correspond à au moins un élément du troisième groupe principal du système périodique, choisi dans le groupe Al, Ga et In, lequel procédé comprend les étapes suivantes :

a) réalisation d'un procédé selon l'une des revendications 2 à 10 en vue de former un monocristal III-N, et
b) séparation du monocristal en vue de former des tranches.

12. Monocristal III-N adhérant à un substrat étranger, dans lequel III correspond à au moins un élément du troisième groupe principal du système périodique, choisi dans le groupe Al, Ga et In, et dans lequel une couche cristalline III-N sur le substrat ainsi qu'une couche cristalline III-N qui a fait sa croissance épitaxiale par-dessus et qui forme le cristal III-N sont constituées du même matériau III-N, **caractérisé en ce que** le monocristal III-N a la valeur de déformation $\varepsilon_{xx}$ suivante (i) :

(i) dans la plage de température d'une croissance cristalline épitaxiale, la valeur $\varepsilon_{xx}$ est < 0 ; et

présente optionnellement la valeur de déformation $\varepsilon_{xx}$ suivante :

(ii) à température ambiante, la valeur $\varepsilon_{xx}$ est < 0 lorsque le monocristal III-N est réalisé sous la forme d'un substrat composite avec une épaisseur de couche du monocristal III-N appliqué sur le substrat dans la plage de 0,1 à 10 $\mu$m,

ou le monocristal III-N présente les valeurs de déformation $\varepsilon_{xx}$ suivantes :

$\varepsilon_{xx}$ <0, de préférence dans une plage de 0> $\varepsilon_{xx}$ > -0,0005, dans la plage de température d'une croissance cristalline épitaxiale ainsi qu'à la température ambiante lorsque le monocristal III-N est réalisé avec une épaisseur de couche d'au moins 1 mm,

$\varepsilon_{xx}$ étant déterminée à l'aide d'une mesure aux rayons X de la constante de réseau absolue, et

le substrat étranger étant choisi dans le groupe comprenant le $LiAlO_2$, le saphir, le SiC et le Si.

13. Monocristal III-N selon la revendication 12 sous la forme d'un substrat composite avec une épaisseur de couche du monocristal III-N appliqué sur le substrat de 2 à 5 $\mu$m.

14. Monocristal III-N selon la revendication 12 ou 13, **caractérisé en ce que** le substrat étranger comprend du saphir, de préférence est constitué de saphir, et/ou **en ce que** le cristal a été fabriqué par un procédé selon l'une quelconque des revendications 1 à 10.

15. Utilisation d'un monocristal III-N selon l'une des revendications 12 à 14 en vue de la fabrication de couches III-N plus épaisses ou de boules de cristal ou cristaux massifs III-N, qui sont optionnellement isolés ensuite en tranches III-N individuelles, et/ou utilisation de tranches III-N fabriquées selon la revendication 11, ou utilisation d'un monocristal III-N selon l'une quelconque des revendications 12 à 14, à chaque fois en vue de la fabrication de composants semi-conducteurs, composants électroniques ou optoélectroniques.

# Figur 1

(i) Querschnitt des Substrates bei Raumtemperatur

(ii) Querschnitt des Substrates bei Desorptionstemperatur

(iii) Querschnitt des Substrates mit III-N-Nukleationsschicht bei Nukleationstemperatur

(iv) Querschnitt des Substrates nach Rekristallation und Wachstum bis zur beginnenden Koaleszenz der III-N-Schicht bei Rekristallisationstemperatur

(v) Querschnitt des Substrates mit darauf befindlicher III-N-Schicht bei zweiter Wachstumstemperatur und vollständiger Koaleszenz

(vi) Querschnitt des Substrates mit kompressiv verspannter abgeschiedener III-N-Schicht und mit geringer Krümmung

Figur 2

## Figur 3

## Fig. 4

Figur 5

Fig. 6 A

Fig. 6 B

Fig. 7A

Fig. 7B

Fig. 7C

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20090092815 A
- US 6440823 B1
- US 20020068201 A1
- US 2003023457 A1
- WO 2007068756 A1
- WO 2006035212 A1
- WO 2008096168 A1
- WO 2008087452 A1
- EP 2136390 A2
- WO 2007107757 A2
- DE 102005023302 A1
- EP 000002299236 A1

**In der Beschreibung aufgeführte Nicht-Patentliteratur**

- **HEARNE et al.** *Applied Physics Letters,* 1999, vol. 74, 356-358
- **NAPIERALA.** *Journal of Crystal Growth,* 2006, vol. 289, 445-449
- **E. RICHTER ; U.ZEIMER ; S.HAGEDORN ; M.WAGNER ; F.BRUNNER ; M.WEYERS ; G.TRÄNKLE.** *Journal of Crystal Growth,* 2010, vol. 312, 2537
- **BRUNNER.** *Journal of Crystal Growth,* 2007, vol. 298, 202-206
- **E. RICHTER ; M. GRÜNDER ; B. SCHINELLER ; F. BRUNNER ; U. ZEIMER ; C. NETZEL ; M. WEYERS ; G. TRÄNKLE.** *Phys. Status Solidi C,* 2011, vol. 8 (5), 1450
- **F. BRUNNER ; A. KNAUER ; T. SCHENK ; M. WEYERS ; J.-T. ZETTLER.** *Journal of Crystal Growth,* 2008, vol. 310, 2432-2438
- **V. DARAKCHIEVA ; B. MONEMAR ; A. USUI ; M. SAENGER ; M. SCHUBERT.** *Journal of Crystal Growth,* 2008, vol. 310, 959-965
- **M. A. MORAM ; M. E. VICKERS.** *Rep. Prog. Phys.,* 2009, vol. 72, 036502
- **HEARNE et al.** *Appl.Physics Letters,* 2007, vol. 74, 356-358
- **I. AHMAD ; M. HOLTZ ; N. N. FALEEV ; H. TEMKIN.** *J. Appl. Phys.,* 2004, vol. 95, 1692
- **J. SHEN ; S. JOHNSTON ; S. SHANG ; T. ANDER-SON.** *J. Cryst. Growth,* 2002, vol. 6, 240